# EUROPEAN PATENT APPLICATION

(11) **EP 2 395 544 A1**
(43) Date of publication of application: **14.12.2011**
(21) Application number: 10738428.1
(22) Date of filing: 25.01.2010
(51) Int. Cl.: H01L 21/225, H01L 31/04

(54) **SEMICONDUCTOR DEVICE PRODUCING METHOD AND SEMICONDUCTOR DEVICE**

(30) Priority: 05.02.2009 JP 2009025140; 06.02.2009 JP 2009026406
(71) Applicant: Sharp Kabushiki Kaisha, Osaka-shi, Osaka 545-8522 (JP)
(72) Inventor: NAKAMURA, Kyotaro, Osaka 545-8522 (JP)
(74) Representative: Müller - Hoffmann & Partner
(86) International application number: PCT/JP2010/050896
(87) International publication number: WO 2010/090090

(57) **Abstract**

Disclosed are a semiconductor device producing method and a semiconductor device. The semiconductor device producing method is comprised of a step of forming a diffusion suppressing mask (2) composed of at least two of a thick film portion (2a), an opening portion (2b), and a thin film portion (2c), on a surface of a semiconductor substrate (1); a step of applying dopant diffusing agents (3, 4, 72, 73) containing dopants to the entirety of a surface of the diffusion suppression mask (2); and a step of diffusing the dopants obtained from the dopant diffusing agents (3, 4, 72, 73) onto the surface of the semiconductor substrate (1). In the semiconductor device, a high concentration first conductive dopant diffusion layer (5), a high concentration second conductive dopant diffusion layer (6), a low concentration first conductive dopant diffusion layer (16), and a low concentration second conducive dopant diffusion layer (17) are provided on one of the surfaces of the semiconductor substrate (1).

## Description

### TECHNICAL FIELD

The present invention relates to a semiconductor device producing method, and more particularly, it relates to a semiconductor device producing method by which a high-concentration dopant diffusion layer and a low-concentration dopant diffusion layer can be stably formed on desired positions.

The present invention relates to a semiconductor device producing method, and more particularly, it relates to a semiconductor device producing method by which the interval between a first conductivity type dopant diffusion layer and a second conductivity type dopant diffusion layer formed on a rear surface of a semiconductor substrate can be set to a prescribed small interval.

Further, the present invention relates to a semiconductor device, and more particularly, it relates to a semiconductor device in which a high-concentration dopant diffusion layer and a low-concentration dopant diffusion layer can be stably formed on desired positions.

### BACKGROUND ART

In recent years, expectation for a solar cell, converting sunlight energy to electric energy, as a next-generation energy source has abruptly been increased, particularly in view of protection of the global environment.

While various types of solar cells such as that employing a compound semiconductor and that employing an organic material are present, a solar cell employing a silicon crystal forms the mainstream at present. A solar cell most produced and sold at present is produced by forming an n electrode on a surface (photoreceiving surface) of a side receiving sunlight and forming a p electrode on a surface (rear surface) opposite to the photoreceiving surface.

In the pamphlet of International Patent Publication No. 2007/081510 (Patent Document 1), there is disclosed a method of producing a rear electrode type solar cell by forming an n electrode and a p electrode only on a rear surface, while forming no electrode on a photoreceiving surface of the solar cell.

The method of producing a rear electrode type solar cell described in Patent Document 1 is now described with reference to schematic sectional views of Fig. 20(a) and Fig. 20(b).

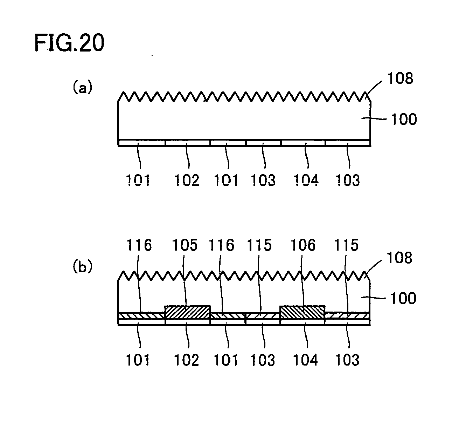

First, low-concentration n-type dopant sources 101, a high-concentration n-type dopant source 102, low-concentration p-type dopant sources 103 and a high-concentration p-type dopant source 104 are formed on a rear surface of a silicon substrate 100 opposite to a side provided with a textured structure 108 by ink jet printing or screen printing, as shown in Fig. 20(a).

Then, as shown in Fig. 20(b), it is assumed that silicon substrate 100 is heat-treated for forming low-concentration n-type dopant diffusion layers 116 on the rear surface of silicon substrate 100 by diffusing an n-type dopant from low-concentration n-type dopant sources 101 in low concentrations while forming a high-concentration n-type dopant diffusion layer 105 by diffusing the n-type dopant from high-concentration n-type dopant source 102 in a high concentration and further forming low-concentration p-type dopant diffusion layers 115 by diffusing a p-type dopant from low-concentration p-type dopant sources 103 in low concentrations while forming a high-concentration p-type dopant diffusion layer 106 by diffusing the p-type dopant from high-concentration p-type dopant source 104 in a high concentration.

Also in Japanese Patent Laying-Open No. 2008-78665 (Patent Document 2), for example, there is disclosed a method of producing a rear electrode type solar cell by forming an n electrode and a p electrode only on a rear surface while forming no electrode on a photoreceiving surface of the solar cell.

The method of producing a rear electrode type solar cell described in Patent Document 2 is now described with reference to schematic sectional views of Fig. 21(a) to Fig.21(e).

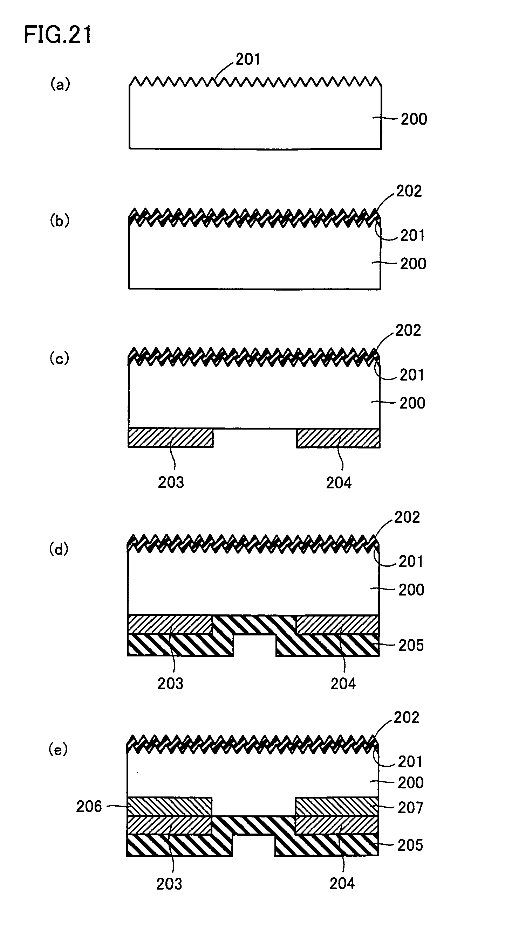

First, a textured structure 201 is formed by texture-etching a surface of a silicon substrate 200, as shown in Fig. 21(a).

Then, a reflection preventing film 202 is formed on textured structure 201 on the surface of silicon substrate 200, as shown in Fig. 21(b).

Then, boron paste 203 containing boron as a p-type dopant and phosphorus paste 204 containing phosphorus as an n-type dopant are formed on a rear surface of silicon substrate 200 opposite to the side provided with textured structure 201 by screen printing, as shown in Fig. 21(c).

Then, a silicon oxide film 205 is formed to cover boron paste 203 and phosphorus paste 204 on the rear surface of silicon substrate 200, as shown in Fig. 21(d).

Then, silicon substrate 200 is heat-treated for forming a p⁺ layer 206 and an n⁺ layer 207 on the rear surface of silicon substrate 200 by diffusing boron from boron paste 203 on the rear surface of silicon substrate 200 and diffusing phosphorus from phosphorus paste 204, as shown in Fig. 21(e).

In the method described in Patent Document 2, boron paste 203 and phosphorus paste 204 on the rear surface of silicon substrate 200 are covered with silicon oxide film 205, and hence it is assumed that out diffusion (external diffusion) of boron from boron paste 203 and out diffusion (external diffusion) of phosphorus from phosphorus paste 204 in the heat treatment of silicon substrate 200 can be avoided.

Thereafter a rear electrode type solar cell is produced by forming a p electrode in contact with p⁺ layer 206 and an n electrode in contact with n⁺ layer 207 after removing silicon oxide film 205 from the rear surface of silicon substrate 200.

### CITATION LIST

### PATENT LITERATURE

PTL 1: Pamphlet of International Patent Publication No. 2007/081510
PTL 2: Japanese Patent Laying-Open No. 2008-78665

### SUMMARY OF INVENTION

### TECHNICAL PROBLEM

It has been proved by recent studies that a rear electrode type solar cell having high characteristics is obtained in a case where low-concentration dopant diffusion layers such as low-concentration n-type dopant diffusion layers 116 and low-concentration p-type dopant diffusion layers 115 are formed between high-concentration dopant diffusion layers of different conductivity types such as high-concentration n-type dopant diffusion layer 105 and high-concentration p-type dopant diffusion layer 106 on the rear surface of silicon substrate 100, as shown in Fig. 20(b).

In the aforementioned method described in Patent Document 1, however, the heat treatment of silicon substrate 100 is performed after forming low-concentration n-type dopant sources 101, high-concentration n-type dopant source 102, low-concentration p-type dopant sources 103 and high-concentration p-type dopant source 104 by ink jet printing or screen printing.

In the method described in Patent Document 1, therefore, the dopants so out-diffuse (externally diffuse) from the aforementioned dopant sources in the heat treatment of silicon substrate 100 that the dopants of different conductivity types mutually diffuse, and hence there has been such a problem that the diffusion of the dopants on the rear surface of the silicon substrate cannot be controlled and high-concentration n-type dopant diffusion layer 105, high-concentration p-type dopant diffusion layer 106, low-concentration n-type dopant diffusion layers 116 and low-concentration p-type dopant diffusion layers 115 cannot be stably formed on desired positions as shown in Fig. 20(b), for example.

In the aforementioned method of producing a rear electrode type solar cell described in Patent Document 2, positions for forming p⁺ layer 206 and n⁺ layer 207 are controlled by the screen printing of boron paste 203 and phosphorus paste 204 respectively, and hence it has been difficult to form p⁺ layer 206 and n⁺ layer 207 at a small interval therebetween.

While it is known that the characteristics of a rear electrode type solar cell improve as the interval between a p⁺ layer and an n⁺ layer on a rear surface of a semiconductor substrate such as a silicon substrate is reduced, the characteristics of a rear electrode type solar cell obtained by the method described in Patent Document 2 are limited.

The aforementioned problems are not limited to the rear electrode type solar cell, but are common also to the whole semiconductor device including a solar cell such as the rear electrode type solar cell.

In consideration of the aforementioned circumstances, an object of the present invention is to provide a semiconductor device producing method by which a high-concentration dopant diffusion layer and a low-concentration dopant diffusion layer can be stably formed on desired positions.

Another object of the present invention is to provide a semiconductor device producing method by which the interval between a first conductivity type dopant diffusion layer and a second conductivity type dopant diffusion layer formed on a rear surface of a semiconductor substrate can be set to a prescribed small interval.

Further, still another object of the present invention is to provide a semiconductor device in which a high-concentration dopant diffusion layer and a low-concentration dopant diffusion layer can be stably formed on desired positions.

### SOLUTION TO PROBLEM

The present invention provides a semiconductor device producing method including the steps of forming a diffusion suppressing mask having an opening and a thick film portion on a surface of a semiconductor substrate, applying a dopant diffusing agent containing a first conductivity type or second conductivity type dopant to cover at least part of a surface of the diffusion suppressing mask, forming a high-concentration dopant diffusion layer by diffusing the dopant into the surface of the semiconductor substrate from the dopant diffusing agent through the opening of the diffusion suppressing mask and forming a low-concentration dopant diffusion layer by diffusing the dopant into the surface of the semiconductor substrate from the dopant diffusing agent through the thick film portion of the diffusion suppressing mask.

The present invention also provides a semiconductor device producing method including the steps of forming a diffusion suppressing mask having a thin film portion and a thick film portion having a larger film thickness than the thin film portion on a surface of a semiconductor substrate, applying a dopant diffusing agent containing a first conductivity type or second conductivity type dopant to cover at least part of a surface of the diffusion suppressing mask, forming a high-concentration dopant diffusion layer by diffusing the dopant into the surface of the semiconductor substrate from the dopant diffusing agent through the thin film portion of the diffusion suppressing mask and forming a low-concentration dopant diffusion layer by diffusing the dopant into the surface of the semiconductor substrate from the dopant diffusing agent through the thick film portion of the diffusion suppressing mask.

The present invention further provides a semiconductor device producing method including the steps of forming a diffusion suppressing mask having an opening, a thin film portion and a thick film portion having a larger film thickness than the thin film portion on a surface of a semiconductor substrate, applying a dopant diffusing agent containing a first conductivity type or second conductivity type dopant to cover at least part of a surface of the diffusion suppressing mask, forming a high-concentration dopant diffusion layer by diffusing the dopant into the surface of the semiconductor substrate from the dopant diffusing agent through at least one of the opening and the thin film portion of the diffusion suppressing mask and forming a low-concentration dopant diffusion layer by diffusing the dopant into the surface of the semiconductor substrate from the dopant diffusing agent through the thick film portion of the diffusion suppressing mask.

The semiconductor device producing method according to the present invention preferably further includes a step of diffusing the dopant into the surface of the semiconductor substrate from dopant-containing gas containing the first conductivity type or second conductivity type dopant through the diffusion suppressing mask.

In the semiconductor device producing method according to the present invention, the dopant concentration in the high-concentration dopant diffusion layer is preferably at least 1 × 10¹⁹/cm³.

In the semiconductor device producing method according to the present invention, the dopant concentration in the low-concentration dopant diffusion layer is preferably at least 1 × 10¹⁷/cm³ and less than 1 × 10¹⁹/cm³.

The present invention further provides a semiconductor device producing method including the steps of forming a diffusion suppressing mask having an opening and a thick film portion on a surface of a semiconductor substrate, applying a dopant diffusing agent containing a first conductivity type or second conductivity type dopant to cover at least part of a surface of the diffusion suppressing mask and diffusing the dopant into the surface of the semiconductor substrate from the dopant diffusing agent.

In the semiconductor device producing method according to the present invention, a dopant diffusion layer is preferably formed on a surface region of the semiconductor substrate corresponding to the opening of the diffusion suppressing mask in the step of diffusing the dopant.

The present invention further provides a semiconductor device producing method including the steps of forming a diffusion suppressing mask having a thin film portion and a thick film portion having a larger film thickness than the thin film portion on a surface of a semiconductor substrate, applying a dopant diffusing agent containing a first conductivity type or second conductivity type dopant to cover at least part of a surface of the diffusion suppressing mask and diffusing the dopant into the surface of the semiconductor substrate from the dopant diffusing agent.

In the semiconductor device producing method according to the present invention, a dopant diffusion layer is preferably formed on a surface region of the semiconductor substrate corresponding to the thin film portion of the diffusion suppressing mask in the step of diffusing the dopant.

The present invention further provides a semiconductor device producing method including the steps of forming a diffusion suppressing mask having an opening, a thin film portion and a thick film portion having a larger film thickness than the thin film portion on a surface of a semiconductor substrate, applying a dopant diffusing agent containing a first conductivity type or second conductivity type dopant to cover at least part of a surface of the diffusion suppressing mask and diffusing the dopant into the surface of the semiconductor substrate from the dopant diffusing agent.

In the semiconductor device producing method according to the present invention, a dopant diffusion layer is preferably formed on surface regions of the semiconductor substrate corresponding to the opening and the thin film portion of the diffusion suppressing mask respectively.

The semiconductor device producing method according to the present invention preferably further includes a step of diffusing the dopant into the surface of the semiconductor substrate from dopant-containing gas containing the first conductivity type or second conductivity type dopant.

In the semiconductor device producing method according to the present invention, the thick film portion preferably has a thickness preventing the dopant from reaching the surface of the semiconductor substrate.

The present invention further provides a semiconductor device including a semiconductor substrate, and a high-concentration first conductivity type dopant diffusion layer, a high-concentration second conductivity type dopant diffusion layer, a low-concentration first conductivity type dopant diffusion layer and a low-concentration second dopant diffusion layer formed on one surface side of the semiconductor substrate, in which the high-concentration first conductivity type dopant diffusion layer and the high-concentration second conductivity type dopant diffusion layer are formed at an interval, the low-concentration first conductivity type dopant diffusion layer is arranged adjacently to the high-concentration first conductivity type dopant diffusion layer while the low-concentration second conductivity type dopant diffusion layer is arranged adjacently to the high-concentration second conductivity type dopant diffusion layer, and the low-concentration first conductivity type dopant diffusion layer and the low-concentration second conductivity type dopant diffusion layer are adjacent to each other between the high-concentration first conductivity type dopant diffusion layer and the high-concentration second conductivity type dopant diffusion layer.

In the semiconductor device producing method according to the present invention, the aforementioned step of forming the high-concentration dopant diffusion layer and the aforementioned step of forming the low-concentration dopant diffusion layer may be carried out at the same time, or may not be carried out at the same time.

In the semiconductor device producing method according to the present invention, further, the step order of the aforementioned step of forming the high-concentration dopant diffusion layer and the aforementioned step of forming the low-concentration dopant diffusion layer is not particularly restricted either.

### ADVANTAGEOUS EFFECTS OF INVENTION

According to the present invention, a semiconductor device producing method by which a high-concentration dopant diffusion layer and a low-concentration dopant diffusion layer can be stably formed on desired positions can be provided.

According to the present invention, a semiconductor device producing method by which the interval between a first conductivity type dopant diffusion layer and a second conductivity type dopant diffusion layer formed on a rear surface of a semiconductor substrate can be set to a prescribed small interval can be provided.

According to the present invention, further, a semiconductor device in which a high-concentration dopant diffusion layer and a low-concentration dopant diffusion layer can be stably formed on desired positions can be provided.

### BRIEF DESCRIPTION OF DRAWINGS

Fig. 1(a) to Fig. 1(j) are schematic sectional views illustrating an example of a solar cell producing method which is an example of a semiconductor device producing method according to the present invention.
Fig. 2 is a schematic plan view of the rear surface of a rear electrode type solar cell prepared by the solar cell producing method which is an example of the semiconductor device producing method according to the present invention.
Fig. 3(a) to Fig. 3(j) are schematic sectional views illustrating another example of the solar cell producing method which is an example of the semiconductor device producing method according to the present invention.
Fig. 4(a) to Fig. 4(j) are schematic sectional views illustrating still another example of the solar cell producing method which is an example of the semiconductor device producing method according to the present invention.
Fig. 5(a) to Fig. 5(j) are schematic sectional views illustrating a further example of the solar cell producing method which is an example of the semiconductor device producing method according to the present invention.
Fig. 6(a) to Fig. 6(k) are schematic sectional views illustrating a further example of the solar cell producing method which is an example of the semiconductor device producing method according to the present invention.
Fig. 7(a) to Fig. 7(f) are schematic sectional views illustrating a further example of the solar cell producing method which is an example of the semiconductor device producing method according to the present invention.
Fig. 8(a) to Fig. 8(c) are schematic sectional views illustrating a further example of the solar cell producing method which is an example of the semiconductor device producing method according to the present invention.
Fig. 9(a) to Fig. 9(d) are schematic sectional views illustrating a further example of the solar cell producing method which is an example of the semiconductor device producing method according to the present invention.
Fig. 10(a) to Fig. 10(d) are schematic sectional views illustrating a further example of the solar cell producing method which is an example of the semiconductor device producing method according to the present invention.
Fig. 11(a) to Fig. 11(j) are schematic sectional views illustrating a further example of the solar cell producing method which is an example of the semiconductor device producing method according to the present invention.
Fig. 12 is a schematic plan view of the rear surface of a rear electrode type solar cell prepared by the example of the solar cell producing method which is an example of the semiconductor device producing method according to the present invention.
Fig. 13(a) to Fig. 13(j) are schematic sectional views illustrating a further example of the solar cell producing method which is an example of the semiconductor device producing method according to the present invention.
Fig. 14(a) to Fig. 14(j) are schematic sectional views illustrating a further example of the solar cell producing method which is an example of the semiconductor device producing method according to the present invention.
Fig. 15(a) to Fig. 15(j) are schematic sectional views illustrating a further example of the solar cell producing method which is an example of the semiconductor device producing method according to the present invention.
Fig. 16(a) to Fig. 16(k) are schematic sectional views illustrating a further example of the solar cell producing method which is an example of the semiconductor device producing method according to the present invention.
Fig. 17(a) to Fig. 17(c) are schematic sectional views illustrating a further example of the solar cell producing method which is an example of the semiconductor device producing method according to the present invention.
Fig. 18(a) to Fig. 18(d) are schematic sectional views illustrating a further example of the solar cell producing method which is an example of the semiconductor device producing method according to the present invention.
Fig. 19(a) to Fig. 19(d) are schematic sectional views illustrating a further example of the solar cell producing method which is an example of the semiconductor device producing method according to the present invention.
Fig. 20(a) and Fig. 20(b) are schematic sectional views illustrating a method of producing a rear electrode type solar cell described in Patent Document 1.
Fig. 21(a) to Fig. 21(e) are schematic sectional views illustrating a method of producing a rear electrode type solar cell described in Patent Document 2.

### DESCRIPTION OF EMBODIMENTS

Embodiments of the present invention are now described. In the drawings of the present invention, it is assumed that the same reference signs denote identical portions or corresponding portions.

### <First Embodiment>

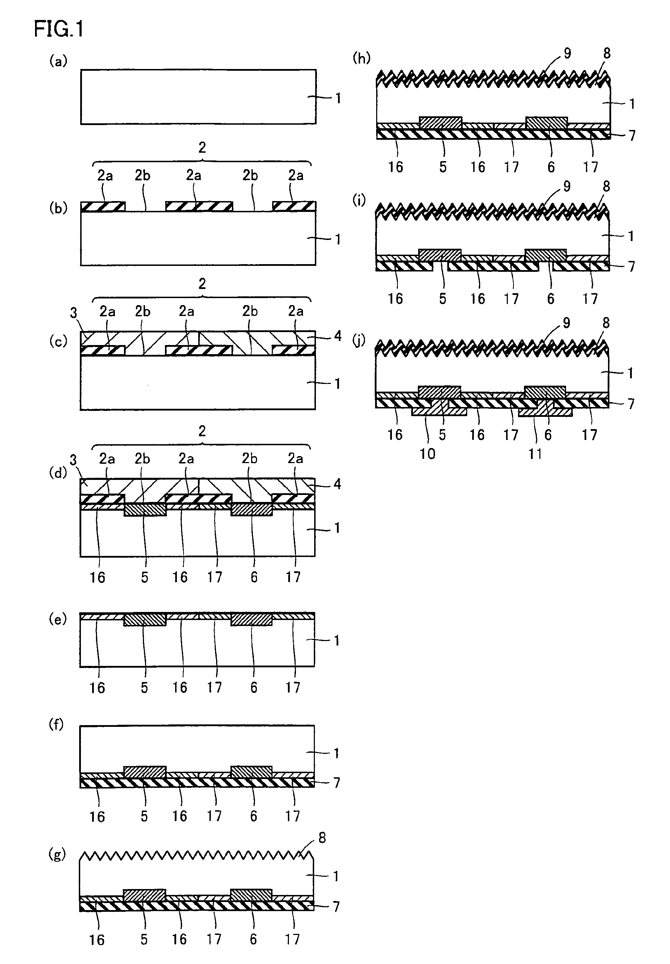

An example of a solar cell producing method which is an example of the semiconductor device producing method according to the present invention is described with reference to schematic sectional views of Fig. 1(a) to Fig. 1(j).

First, a semiconductor substrate 1 is prepared, as shown in Fig. 1(a). While any substrate can be employed as semiconductor substrate 1 without particular restriction so far as the same is a substrate made of a semiconductor, a silicon substrate or the like obtained by slicing a silicon ingot can be employed, for example. The conductivity type of semiconductor substrate 1 is not particularly restricted either, but semiconductor substrate 1 may have n-type conductivity, may have p-type conductivity, or may have neither of the n-type conductivity and the p-type conductivity.

In a case of employing a silicon substrate as semiconductor substrate 1, a silicon substrate from which a slice damage caused by slicing a silicon ingot has been removed may be employed, for example. Removal of the aforementioned slice damage can be performed by etching the surface of the silicon substrate after the slicing with mixed acid of aqueous hydrogen fluoride and nitric acid or aqueous alkali such as sodium hydroxide, for example.

The size and the shape of semiconductor substrate 1 are not particularly restricted, but semiconductor substrate 1 can have such a quadrangular surface that the thickness is set to at least 100 µm and not more than 300 µm and the length of each side is set to at least 100 mm and not more than 200 mm, for example.

Then, a diffusion suppressing mask 2 is formed on one surface of semiconductor substrate 1, as shown in Fig. 1(b). Diffusion suppressing mask 2 is constituted of openings 2b having no film thickness and thick film portions 2a having a film thickness.

The film thickness of thick film portions 2a of diffusion suppressing mask 2 is not particularly restricted, so far as a first conductivity type dopant or a second conductivity type dopant diffuses through thick film portions 2a and low-concentration dopant diffusion layers described later can be formed.

Diffusion suppressing mask 2 (thick film portions 2a of diffusion suppressing mask 2 in this embodiment) can be formed by a method of applying masking paste having openings in portions corresponding to the portions for forming openings 2b to the surface of semiconductor substrate 1 and thereafter firing the masking paste, for example. As the method of applying the masking paste, spray coating, coating employing a dispenser, ink jet printing, screen printing, letterpress printing, intaglio printing or flat plate printing can be employed, for example.

As the masking paste, paste such as that containing a solvent and a thickener as well as a silicon oxide precursor and/or a titanium oxide precursor can be employed, for example. Paste containing no thickener can also be employed as the masking paste.

As the solvent, one of or a combination of at least two of ethylene glycol, methyl cellosolve, methyl cellosolve acetate, ethyl cellosolve, diethyl cellosolve, cellosolve acetate, ethylene glycol monophenyl ether, methoxyethanol, ethylene glycol monoacetate, ethylene glycol diacetate, diethylene glycol, diethylene glycol monomethyl ether, diethylene glycol monoethyl ether acetate, diethylene glycol monobutyl ether, diethylene glycol monobutyl ether acetate, diethylene glycol dimethyl ether, diethylene glycol methyl ethyl ether, diethylene glycol diethyl ether, diethylene glycol acetate, triethyl glycol, triethylene glycol monomethyl ether, triethylene glycol monoethyl ether, tetraethylene glycol, liquid polyethylene glycol, propylene glycol, propylene glycol monomethyl ether, propylene glycol monoethyl ether, propylene glycol monobutyl ether, 1-butoxyethoxy propanol, dipropyl glycol, dipropylene glycol monomethyl ether, dipropylene glycol monoethyl ether, tripropylene glycol monomethyl ether, polypropylene glycol, trimethylene glycol, butanedial, 1,5-pentanedial, hexylene glycol, glycerin, gyceryl acetate, glycerin diacetate, glyceryl triacetate, trimethylol propine, 1,2,6-hexanetriol, 1,2-propanediol, 1,5-pentanediol, octanediol, 1,2-butanediol, 1,4-butanediol, 1,3-butanediol, dioxane, trioxane, tetrahydrofuran, tetrahydropyran, methylal, diethyl acetal, methyl ethyl ketone, methyl isobutyl ketone, diethyl ketone, acetonyl acetone, diacetone alcohol, methyl formate, ethyl formate, propyl formate, methyl acetate and ethyl acetate can be employed, for example.

While ethyl cellulose, polyvinyl pyrrolidone or a mixture thereof is desirably employed as the thickener, bentonites of various qualities and characteristics, a generally inorganic rheological additive for various polar solvent mixtures, nitrocellulose and other cellulose compounds, starch, gelatin, alginic acid, highly dispersive amorphous silicic acid (Aerosil (registered trademark)), polyvinyl butyral (Mowital (registered trademark)), sodium carboxymethyl cellulose (vivistar), thermoplastic polyamide resin (Eurelon (registered trademark)), an organic castor oil derivative (Thixin R (registered trademark)), diamide wax (Thixatrol plus (registered trademark)), swollen polyacrylate (Rheolate (registered trademark)), polyetherurea-polyurethane, polyether-polyol or the like can also be employed.

As the silicon oxide precursor, a substance such as TEOS (tetraethyl orthosilicate) expressed in a general formula R'ₙSi(OR)₄₋ₙ (R' represents methyl, ethyl or phenyl, R represents methyl, ethyl, n-propyl or 1-propyl, and n represents 0, 1 or 2) can be employed, for example.

The titanium oxide precursor is a substance such as TPT (tetraisopropoxy titanium) expressed as R'ₙTi(OR)₄₋ₙ (R' represents methyl, ethyl or phenyl, R represents methyl, ethyl, n-propyl or i-propyl, and n represents 0, 1 or 2), in addition to Ti(OH)₄, for example, and also includes TiCl₄, TiF₄, TiOSO₄ or the like.

Diffusion suppressing mask 2 (thick film portions 2a of diffusion suppressing mask 2 in this embodiment) can be formed by forming a single layer or a multilayer film of a silicon oxide film, a silicon nitride film, a titanium oxide film or an aluminum oxide film on the overall surface of semiconductor substrate 1 by CVD (Chemical Vapor Deposition) or the like and thereafter removing part of the film, for example. Part of the film made of the aforementioned material can be removed by a method of forming a resist pattern having openings in portions corresponding to the portions for forming openings 2b on the surface of the aforementioned film by photolithography and thereafter removing the aforementioned film from the openings of the resist pattern by etching or the like or a method of applying etching paste onto the diffusion suppressing mask corresponding to the portions for forming openings 2b and thereafter etching and removing the diffusion suppressing mask by heating, for example.

As the etching paste, that containing phosphoric acid as an etching component and containing water, an organic solvent and a thickener as components other than the etching component can be employed, for example. As the organic solvent, at least one of alcohol such as ethylene glycol, ether such as ethylene glycol monobutyl ether, ester such as propylene carbonate and ketone such as N-methyl-2-pyrrolidone can be employed, for example. As the thickener, at least one of cellulose, ethyl cellulose, a cellulose derivative, polyamide resin such as Nylon 6, a polymer such as polyvinyl pyrrolidone prepared by polymerizing a vinyl group and the like can be employed, for example.

Then, a first conductivity type dopant diffusing agent 3 containing a first conductivity type dopant and a second conductivity type dopant diffusing agent 4 containing a second conductivity type dopant are applied to cover diffusion suppressing mask 2 on the surface of semiconductor substrate 1, as shown in Fig. 1(c).

As the methods of applying first conductivity type dopant diffusing agent 3 and second conductivity type dopant diffusing agent 4, spray coating, coating employing a dispenser, ink jet printing, screen printing, letterpress printing, intaglio printing or flat plate printing can be employed, for example.

A material containing a first conductivity type dopant source can be employed as first conductivity type dopant diffusing agent 3, and as the first conductivity type dopant source, one of or a combination of at least two of phosphate, phosphorus oxide, diphosphorus pentaoxide, phosphoric acid and a compound such as an organic phosphorus compound containing phosphorus atoms, for example, can be employed if the first conductivity type is the n type, while one of or a combination of at least two of boron oxide, boric acid and compounds such as an organic boron compound, a boron-aluminum compound, an organic aluminum compound and aluminum salt containing boron atoms and/or aluminum atoms, for example, can be employed if the first conductivity type is the p type.

A material containing a second conductivity type dopant source can be employed as second conductivity type dopant diffusing agent 4, and as the second conductivity type dopant source, one of or a combination of at least two of boron oxide, boric acid and compounds such as an organic boron compound, a boron-aluminum compound, an organic aluminum compound and aluminum salt containing boron atoms and/or aluminum atoms, for example, can be employed if the second conductivity type is the p type, while one of or a combination of at least two of phosphate, phosphorus oxide, diphosphorus pentaoxide, phosphoric acid and a compound such as an organic phosphorus compound containing phosphorus atoms, for example, can be employed if the second conductivity type is the n type.

Each of first conductivity type dopant diffusing agent 3 and second conductivity type dopant diffusing agent 4 may contain a solvent and a thickener. As the solvent and the thickener contained in each of first conductivity type dopant diffusing agent 3 and second conductivity type dopant diffusing agent 4, one of or a combination of at least two of those described as the solvent and the thickener containable in the masking paste in the above can be employed, for example.

Then, semiconductor substrate 1 is heat-treated for forming a high-concentration first conductivity type dopant diffusion layer 5 and low-concentration first conductivity type dopant diffusion layers 16 by diffusing the first conductivity type dopant into the surface of semiconductor substrate 1 from first conductivity type dopant diffusing agent 3 and forming a high-concentration second conductivity type dopant diffusion layer 6 and low-concentration second conductivity type dopant diffusion layers 17 by diffusing the second conductivity type dopant into the surface of semiconductor substrate 1 from second conductivity type dopant diffusing agent 4, as shown in Fig. 1(d).

In consequence of the aforementioned heat treatment of semiconductor substrate 1, the first conductivity type dopant diffuses into the surface of semiconductor substrate 1 from first conductivity type dopant diffusing agent 3 through openings 2b of diffusion suppressing mask 2 so that high-concentration first conductivity type dopant diffusion layer 5 is formed, and the first conductivity type dopant diffuses into the surface of semiconductor substrate 1 from first conductivity type dopant diffusing agent 3 through thick film portions 2a of diffusion suppressing mask 2 so that low-concentration first conductivity type dopant diffusion layers 16 are formed. Needless to say, high-concentration first conductivity type dopant diffusion layer 5 has a higher first conductivity type dopant concentration than low-concentration first conductivity type dopant diffusion layers 16.

In consequence of the aforementioned heat treatment of semiconductor substrate 1, further, the second conductivity type dopant diffuses into the surface of semiconductor substrate 1 from second conductivity type dopant diffusing agent 4 through openings 2b of diffusion suppressing mask 2 so that high-concentration second conductivity type dopant diffusion layer 6 is formed, and the second conductivity type dopant diffuses into the surface of semiconductor substrate 1 from second conductivity type dopant diffusing agent 4 through thick film portions 2a of diffusion suppressing mask 2 so that low-concentration second conductivity type dopant diffusion layers 17 are formed. Needless to say, high-concentration second conductivity type dopant diffusion layer 6 has a higher second conductivity type dopant concentration than low-concentration second conductivity type dopant diffusion layers 17.

In other words, the first conductivity type dopant and the second conductivity type dopant diffuse from first conductivity type dopant diffusing agent 3 and second conductivity type dopant diffusing agent 4 respectively through diffusion suppressing mask 2 having openings 2b and thick film portions 2a, whereby the quantities of the dopants passing through openings 2b and diffusing into the surface of semiconductor substrate 1 can be rendered larger than the quantities of the dopants diffusing into the surface of semiconductor substrate 1 through thick film portions 2a.

Thus, it follows that the high-concentration dopant diffusion layers (high-concentration first conductivity type dopant diffusion layer 5 and high-concentration second conductivity type dopant diffusion layer 6) are formed on surface regions of semiconductor substrate 1 corresponding to openings 2b of diffusion suppressing mask 2 while the low-concentration dopant diffusion layers (low-concentration first conductivity type dopant diffusion layers 16 and low-concentration second conductivity type dopant diffusion layers 17) are formed on surface regions of semiconductor substrate 1 corresponding to thick film portions 2a of diffusion suppressing mask 2.

While the conditions for the aforementioned heat treatment of semiconductor substrate 1 are not particularly restricted, semiconductor substrate 1 can be heated at a temperature of at least 850°C and not more than 1000°C, for example, for at least 20 minutes and not more than 50 minutes, for example, in order to stably form the high-concentration dopant diffusion layers (high-concentration first conductivity type dopant diffusion layer 5 and high-concentration second conductivity type dopant diffusion layer 6) and the low-concentration second conductivity type dopant diffusion layers (low-concentration first conductivity type dopant diffusion layers 16 and low-concentration second conductivity type dopant diffusion layers 17).

Then, diffusion suppressing mask 2, first conductivity type dopant diffusing agent 3 and second conductivity type dopant diffusing agent 4 are removed from the surface of semiconductor substrate 1, as shown in Fig. 1(e). Thus, it follows that the surfaces of high-concentration first conductivity type dopant diffusion layer 5, high-concentration second conductivity type dopant diffusion layer 6, low-concentration first conductivity type dopant diffusion layers 16 and low-concentration second conductivity type dopant diffusion layers 17 are exposed on the surface of semiconductor substrate 1.

Then, a passivation film 7 is formed on the surface of semiconductor substrate 1 on the side where high-concentration first conductivity type dopant diffusion layer 5, high-concentration second conductivity type dopant diffusion layer 6, low-concentration first conductivity type dopant diffusion layers 16 and low-concentration second conductivity type dopant diffusion layers 17 are exposed, as shown in Fig. 1(f).

As passivation film 7, a silicon oxide film, a silicon nitride film or a multilayer body of a silicon oxide film and a silicon nitride film formed by plasma CVD or the like can be employed, for example.

Then, a textured structure 8 consisting of pyramidal irregularities, for example, is formed on the surface of semiconductor substrate 1 opposite to the side provided with passivation film 7, as shown in Fig. 1(g).

Textured structure 8 can be formed by etching the surface of semiconductor substrate 1, for example. The surface of semiconductor substrate 1 can be etched by etching the surface of semiconductor substrate 1 with an etching solution prepared by heating a liquid obtained by adding isopropyl alcohol to aqueous alkali such as sodium hydroxide or potassium hydroxide, for example, to at least 70°C and not more than 80°C, for example, if semiconductor substrate 1 is formed by a silicon substrate.

Then, a reflection preventing film 9 is formed on textured structure 8 on the surface of semiconductor substrate 1, as shown in Fig. 1(h). For reflection preventing film 9, a silicon oxide film, a silicon nitride film or a multilayer body of a silicon oxide film and a silicon nitride film formed by plasma CVD or the like can be employed, for example.

Then, contact holes are formed by partially removing passivation film 7 from semiconductor substrate 1, for exposing the surfaces of the respective ones of high-concentration first conductivity type dopant diffusion layer 5 and high-concentration second conductivity type dopant diffusion layer 6 from the contact holes, as shown in Fig. 1(i).

The contact holes can be formed by a method of forming a resist pattern having openings in portions corresponding to the portions for forming the contact holes on passivation film 7 by photolithography and thereafter removing passivation film 7 from the openings of the resist pattern by etching or a method of applying etching paste to portions of passivation film 7 corresponding to the portions for forming the contact holes and thereafter etching and removing passivation film 7 by heating, for example. As the etching paste, that similar to the etching paste described in the above can be employed.

Then, a first conductivity type electrode 10 electrically connected to high-concentration first conductivity type dopant diffusion layer 5 and a second conductivity type electrode 11 electrically connected to high-concentration second conductivity type dopant diffusion layer 6 are formed through the contact holes, as shown in Fig. 1(j).

As first conductivity type electrode 10 and second conductivity type electrode 11, electrodes made of metal such as silver can be employed, for example.

Thus, a rear electrode type solar cell can be prepared by the solar cell producing method according to this embodiment.

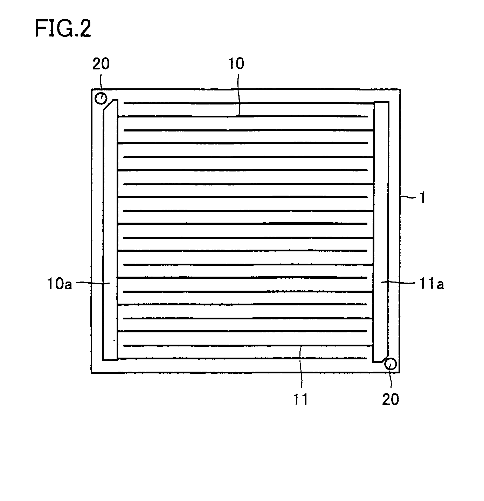

Fig. 2 is a schematic plan view of the rear surface of the rear electrode type solar cell prepared by the solar cell producing method according to this embodiment.

On the rear surface of the rear electrode type solar cell, a plurality of zonal first conductivity type electrodes 10 and a plurality of zonal second conductivity type electrodes 11 are alternately arranged one by one at intervals, while all first conductivity type electrodes 10 are electrically connected to one zonal first conductivity type collecting electrode 10a, and all second conductivity type electrodes 11 are electrically connected to one zonal second conductivity type collecting electrode 11a, as shown in Fig. 2. On the rear surface of semiconductor substrate 1, two circular alignment marks 20 are arranged on diagonal corners of the rear surface of semiconductor substrate 1 respectively.

While it follows that high-concentration first conductivity type dopant diffusion layer 5 is arranged under each of plurality of zonal first conductivity type electrodes 10 and high-concentration second conductivity type dopant diffusion layer 6 is arranged under each of plurality of zonal second conductivity type electrodes 11 on the rear surface of semiconductor substrate 1, the shapes and the sizes of high-concentration first conductivity type dopant diffusion layer 5 and high-concentration second conductivity type dopant diffusion layer 6 are not particularly restricted. For example, high-concentration first conductivity type dopant diffusion layer 5 and high-concentration second conductivity type dopant diffusion layer 6 may be zonally formed along each of first conductivity type electrodes 10 and each of second conductivity type electrodes 11, or may be formed in the shape of dots in contact with part of each of first conductivity type electrodes 10 and each of second conductivity type electrodes 11.

While Fig. 1(a) to Fig. 1(j) show the method as if only one high-concentration first conductivity type dopant diffusion layer 5 and only one high-concentration second conductivity type dopant diffusion layer 6 are formed on semiconductor substrate 1 for the convenience of illustration, a plurality of high-concentration first conductivity type dopant diffusion layers 5 and a plurality of high-concentration second conductivity dopant diffusion layers 6 may be formed in practice, as a matter of course.

In the solar cell producing method according to this embodiment which is an example of the present invention, it follows that the high-concentration dopant diffusion layers (high-concentration first conductivity type dopant diffusion layer 5 and high-concentration second conductivity type dopant diffusion layer 6) and the low-concentration dopant diffusion layers (low-concentration first conductivity type dopant diffusion layers 16 and low-concentration second conductivity type dopant diffusion layers 17) are formed on desired positions due to the setting of diffusion suppressing mask 2 having thick film portions 2a and openings 2b and the dopant diffusing agents (first conductivity type dopant diffusing agent 3 and second conductivity type dopant diffusing agent 4).

Even if the dopants out-diffuse (externally diffuse) from the dopant diffusing agents in the heat treatment of semiconductor substrate 1, therefore, thick film portions 2a of diffusion suppressing mask 2 can effectively inhibit the out-diffusing dopants from diffusing into different portions of the surface of semiconductor substrate 1 in the solar cell producing method according to this embodiment, whereby the high-concentration dopant diffusion layers and the low-concentration dopant diffusion layers can be stably formed on the desired positions, as compared with the method described in the aforementioned Patent Document 1.

In the solar cell producing method according to this embodiment, no steps of patterning diffusion suppressing mask 2 (forming openings 2b of diffusion suppressing mask 2) for forming high-concentration first conductivity type dopant diffusion layer 5 and high-concentration second conductivity type dopant diffusion layer 6 may be carried out in the formation of high-concentration first conductivity type dopant diffusion layer 5 and in the formation of high-concentration second conductivity type dopant diffusion layer 6 (twice in total), whereby the producing steps can be simplified.

In the solar cell producing method according to this embodiment, further, the heat treatment for forming high-concentration first conductivity type dopant diffusion layer 5, high-concentration second conductivity type dopant diffusion layer 6, low-concentration first conductivity type dopant diffusion layers 16 and low-concentration second conductivity type dopant diffusion layers 17 may be carried out only once, whereby the producing steps can be simplified, and thermal damage of semiconductor substrate 1 etc. resulting from the heat treatment can be effectively suppressed.

In the above, the first conductivity type may be either the n type or the p type, and the second conductivity type may simply be the conductivity type reverse to the first conductivity type. In other words, the second conductivity type is the p type when the first conductivity type is the n type, and the second conductivity type is the n type when the first conductivity type is the p type.

A p-type dopant such as boron or aluminum, for example, can be employed as the first conductivity type dopant if the first conductivity type is the p type, while an n-type dopant such as phosphorus, for example, can be employed as the first conductivity type dopant if the first conductivity type is the n type.

An n-type dopant such as phosphorus, for example, can be employed as the second conductivity type dopant if the second conductivity type is the n type, while a p-type dopant such as boron or aluminum, for example, can be employed as the second conductivity type dopant if the second conductivity type is the p type.

In order that the rear electrode type solar cell attains high characteristics, the dopant concentrations in the high-concentration dopant diffusion layers (high-concentration first conductivity type dopant diffusion layer 5 and high-concentration second conductivity type dopant diffusion layer 6) are preferably set to at least 1 × 10¹⁹/cm³_{.}

In order that the rear electrode type solar cell attains high characteristics, further, the dopant concentrations in the low-concentration dopant diffusion layers (low-concentration first conductivity type dopant diffusion layers 16 and low-concentration second conductivity type dopant diffusion layers 17) are preferably set to at least 1 × 10¹⁷/cm³ and less than 1 × 10¹⁹/cm³, and more preferably set to 5 × 10¹⁷/cm³ and not more than 1 × 10¹⁸/cm³.

### <Second Embodiment>

This embodiment is characterized in a point that a diffusion suppressing mask 2 is constituted of an opening 2b, a thin film portion 2c and thick film portions 2a having a larger film thickness than thin film portion 2c. The remaining points are similar to those of the first embodiment.

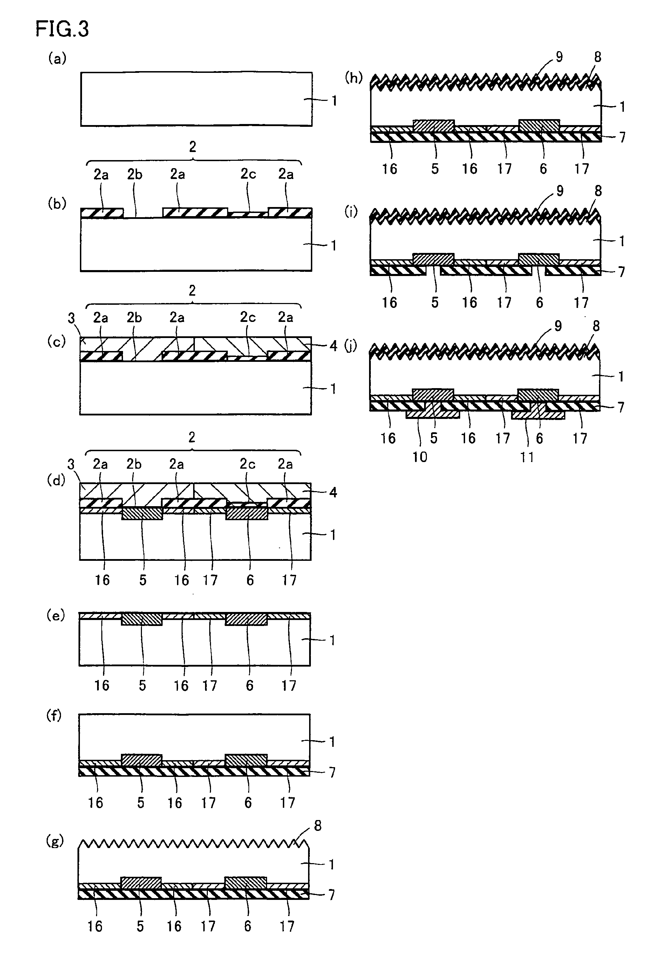

A solar cell producing method according to this embodiment is now described with reference to schematic sectional views of Fig. 3(a) to Fig. 3(j). While Fig. 3(a) to Fig. 3(j) also show the method as if only one high-concentration first conductivity type dopant diffusion layer 5 and only one high-concentration second conductivity type dopant diffusion layer 6 are formed on a semiconductor substrate 1 for the convenience of illustration, a plurality of high-concentration first conductivity type dopant diffusion layers 5 and a plurality of high-concentration second conductivity type dopant diffusion layers 6 may be formed in practice, as a matter of course.

First, semiconductor substrate 1 is prepared as shown in Fig. 3(a), and diffusion suppressing mask 2 having opening 2b, thin film portion 2c and thick film portions 2a having a larger film thickness than thin film portion 2c is then formed on part of the surface of semiconductor substrate 1, as shown in Fig. 3(b). Diffusion suppressing mask 2 in this embodiment can be formed by a method similar to that for diffusion suppressing mask 2 in the first embodiment, for example. Thick film portions 2a and thin film portion 2c of diffusion suppressing mask 2 can be formed by applying masking paste in an overlapping manner by ink jet printing or the like thereby varying the thickness of application of the masking paste, for example.

The thickness of thin film portion 2c of diffusion suppressing mask 2 is not particularly restricted, so far as a first conductivity type or second conductivity type dopant diffuses through thin film portion 2c and high-concentration dopant diffusion layers described later can be formed.

Then, a first conductivity type dopant diffusing agent 3 containing the first conductivity type dopant and a second conductivity type dopant diffusing agent 4 containing the second conductivity type dopant are applied to cover diffusion suppressing mask 2 on the surface of semiconductor substrate 1, as shown in Fig. 3(c). While first conductivity type dopant diffusing agent 3 is formed on a position corresponding to opening 2b of diffusion suppressing mask 2 and second conductivity type dopant diffusing agent 4 is formed on a position corresponding to thin film portion 2c of diffusion suppressing mask 2 in this embodiment, the present invention is not restricted to this structure, but the positions for forming first conductivity type dopant diffusing agent 3 and second conductivity type dopant diffusing agent 4 may be replaced with each other, for example.

First conductivity type dopant diffusing agent 3 and second conductivity type dopant diffusing agent 4 in this embodiment can be applied by a method similar to that for first conductivity type dopant diffusing agent 3 and second conductivity type dopant diffusing agent 4 in the first embodiment, for example.

Then, semiconductor substrate 1 is heat-treated for forming low-concentration first conductivity type diffusion layers 16, high-concentration first conductivity type dopant diffusion layer 5, low-concentration second conductivity type dopant diffusion layers 17 and high-concentration second conductivity type dopant diffusion layer 6 by diffusing the first conductivity type dopant and the second conductivity type dopant into the surface of semiconductor substrate 1 from first conductivity type dopant diffusing agent 3 and second conductivity type dopant diffusing agent 4 respectively, as shown in Fig. 3(d).

In consequence of the aforementioned heat treatment of semiconductor substrate 1, the first conductivity type dopant diffuses into the surface of semiconductor substrate 1 from first conductivity type dopant diffusing agent 3 through opening 2b of diffusion suppressing mask 2 so that high-concentration first conductivity type dopant diffusion layer 5 is formed, and the first conductivity type dopant diffuses into the surface of semiconductor substrate 1 from first conductivity type dopant diffusing agent 3 through thick film portions 2a of diffusion suppressing mask 2 so that low-concentration first conductivity type dopant diffusion layers 16 are formed.

In consequence of the aforementioned heat treatment of semiconductor substrate 1, further, the second conductivity type dopant diffuses into the surface of semiconductor substrate 1 from second conductivity type dopant diffusing agent 4 through thin film portion 2c of diffusion suppressing mask 2 so that high-concentration second conductivity type dopant diffusion layer 6 is formed, and the second conductivity type dopant diffuses into the surface of semiconductor substrate 1 from second conductivity type dopant diffusing agent 4 through thick film portions 2a of diffusion suppressing mask 2 so that low-concentration second conductivity type dopant diffusion layers 17 are formed.

In other words, the first conductivity type dopant and the second conductivity type dopant diffuse from first conductivity type dopant diffusing agent 3 and second conductivity type dopant diffusing agent 4 respectively through diffusion suppressing mask 2 having opening 2b, thin film portion 2c and thick film portions 2a having a larger film thickness than thin film portion 2c also in this case, whereby the quantities of the dopants passing through opening 2b and thin film portion 2c and diffusing into the surface of semiconductor substrate 1 are rendered larger than the quantities of the dopants diffusing into the surface of semiconductor substrate 1 through thick film portions 2a.

Thus, it follows that the high-concentration dopant diffusion layers (high-concentration first conductivity type dopant diffusion layer 5 and high-concentration second conductivity type dopant diffusion layer 6) are formed on surface regions of semiconductor substrate 1 corresponding to opening 2b and thin film portion 2c of diffusion suppressing mask 2 while the low-concentration dopant diffusion layers (low-concentration first conductivity type dopant diffusion layers 16 and low-concentration second conductivity type dopant diffusion layers 17) are formed on surface regions of semiconductor substrate 1 corresponding to thick film portions 2a of diffusion suppressing mask 2 also in this embodiment.

Then, diffusion suppressing mask 2, first conductivity type dopant diffusing agent 3 and second conductivity type dopant diffusing agent 4 are removed from the surface of semiconductor substrate 1 thereby exposing the surfaces of high-concentration first conductivity type dopant diffusion layer 5, high-concentration second conductivity type dopant diffusion layer 6, low-concentration first conductivity type dopant diffusion layers 16 and low-concentration second conductivity type dopant diffusion layers 17 on the surface of semiconductor substrate 1, as shown in Fig. 3(e).

Then, a passivation film 7 is formed on the surface of semiconductor substrate 1 on the side where high-concentration first conductivity type dopant diffusion layer 5, high-concentration second conductivity type dopant diffusion layer 6, low-concentration first conductivity type dopant diffusion layers 16 and low-concentration second conductivity type dopant diffusion layers 17 are exposed, as shown in Fig. 3(f).

Then, a textured structure 8 consisting of pyramidal irregularities, for example, is formed on the surface of semiconductor substrate 1 opposite to the side provided with passivation film 7, as shown in Fig. 3(g).

Then, a reflection preventing film 9 is formed on textured structure 8 on the surface of semiconductor substrate 1, as shown in Fig. 3(h).

Then, contact holes are formed by partially removing passivation film 7 from semiconductor substrate 1, for exposing the surfaces of the respective ones of high-concentration first conductivity type dopant diffusion layer 5 and high-concentration second conductivity type dopant diffusion layer 6 from the contact holes, as shown in Fig. 3(i).

Then, a first conductivity type electrode 10 electrically connected to high-concentration first conductivity type dopant diffusion layer 5 and a second conductivity type electrode 11 electrically connected to second conductivity type dopant diffusion layer 6 are formed through the contact holes, as shown in Fig. 3(j).

Thus, a rear electrode type solar cell can be prepared by the solar cell producing method according to this embodiment.

Also in the solar cell producing method according to this embodiment which is an example of the present invention, it follows that the high-concentration dopant diffusion layers (high-concentration first conductivity type dopant diffusion layer 5 and high-concentration second conductivity type dopant diffusion layer 6) and the low-concentration dopant diffusion layers (low-concentration first conductivity type dopant diffusion layers 16 and low-concentration second conductivity type dopant diffusion layers 17) are formed on desired positions due to the setting of diffusion suppressing mask 2 having opening 2b, thin film portion 2c and thick film portions 2a and the dopant diffusing agents (first conductivity type dopant diffusing agent 3 and second conductivity type dopant diffusing agent 4).

Even if the dopants out-diffuse (externally diffuse) from the dopant diffusing agents in the heat treatment of semiconductor substrate 1, therefore, thick film portions 2a of diffusion suppressing mask 2 can effectively inhibit the out-diffusing dopants from diffusing into different portions of the surface of semiconductor substrate 1 also in the solar cell producing method according to this embodiment, whereby the high-concentration dopant diffusion layers and the low-concentration dopant diffusion layers can be stably formed on the desired positions, as compared with the method described in the aforementioned Patent Document 1.

Also in the solar cell producing method according to this embodiment, no steps of patterning diffusion suppressing mask 2 (forming opening 2b and thin film portion 2c of diffusion suppressing mask 2) for forming high-concentration first conductivity type dopant diffusion layer 5 and high-concentration second conductivity type dopant diffusion layer 6 may be carried out in the formation of high-concentration first conductivity type dopant diffusion layer 5 and in the formation of high-concentration second conductivity type dopant diffusion layer 6 (twice in total), whereby the producing steps can be simplified.

Also in the solar cell producing method according to this embodiment, further, the heat treatment for forming high-concentration first conductivity type dopant diffusion layer 5, high-concentration second conductivity type dopant diffusion layer 6, low-concentration first conductivity type dopant diffusion layers 16 and low-concentration second conductivity type dopant diffusion layers 17 may be carried out only once, whereby the producing steps can be simplified, and thermal damage of semiconductor substrate 1 etc. resulting from the heat treatment can be effectively suppressed.

Even if the diffusion coefficient of the first conductivity type dopant and the diffusion coefficient of the second conductivity type dopant with respect to semiconductor substrate 1 are remarkably different from each other, diffusion of the dopants can be adjusted by thin film portion 2c in the solar cell producing method according to this embodiment, whereby doping profiles (dopant concentration distribution) of high-concentration first conductivity type dopant diffusion layer 5, high-concentration second conductivity type dopant diffusion layer 6, low-concentration first conductivity type dopant diffusion layers 16 and low-concentration second conductivity type dopant diffusion layers 17 can be rendered more suitable.

Description of this embodiment other than the above is similar to that of the first embodiment, and hence redundant description is not repeated.

### <Third Embodiment>

This embodiment is characterized in a point that a diffusion suppressing mask 2 is constituted of thin film portions 2c and thick film portions 2a having a larger film thickness than thin film portions 2c. The remaining points are similar to those of the first embodiment and the second embodiment.

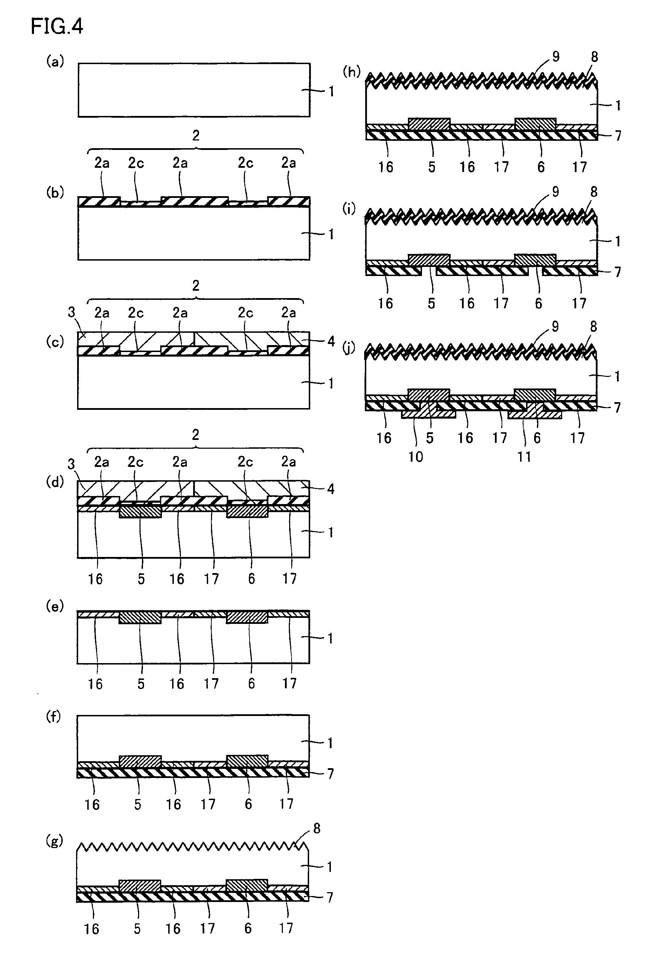

A solar cell producing method according to this embodiment is now described with reference to schematic sectional views of Fig. 4(a) to Fig. 4(j). While Fig. 4(a) to Fig. 4(j) also show the method as if only one high-concentration first conductivity type dopant diffusion layer 5 and only one high-concentration second conductivity type dopant diffusion layer 6 are formed on a semiconductor substrate 1 for the convenience of illustration, a plurality of high-concentration first conductivity type dopant diffusion layers 5 and a plurality of high-concentration second conductivity type dopant diffusion layers 6 may be formed in practice, as a matter of course.

First, semiconductor substrate 1 is prepared as shown in Fig. 4(a), and diffusion suppressing mask 2 having thin film portions 2c and thick film portions 2a having a larger film thickness than thin film portions 2c is then formed on part of the surface of semiconductor substrate 1, as shown in Fig. 4(b). Diffusion suppressing mask 2 in this embodiment can be formed by a method similar to those for diffusion suppressing masks 2 in the first embodiment and the second embodiment, for example.

Then, a first conductivity type dopant diffusing agent 3 containing a first conductivity type dopant and a second conductivity type dopant diffusing agent 4 containing a second conductivity type dopant are applied to cover diffusion suppressing mask 2 on the surface of semiconductor substrate 1, as shown in Fig. 4(c). First conductivity type dopant diffusing agent 3 and second conductivity type dopant diffusing agent 4 in this embodiment can be applied by a method similar to those for first conductivity type dopant diffusing agents 3 and second conductivity type dopant diffusing agents 4 in the first embodiment and the second embodiment, for example.

Then, semiconductor substrate 1 is heat-treated for forming low-concentration first conductivity type dopant diffusion layers 16, high-concentration first conductivity type dopant diffusion layer 5, low-concentration second conductivity type dopant diffusion layers 17 and high-concentration second conductivity type dopant diffusion layer 6 by diffusing the first conductivity type dopant and the second conductivity type dopant into the surface of semiconductor substrate 1 from first conductivity type dopant diffusing agent 3 and second conductivity type dopant diffusing agent 4 respectively, as shown in Fig. 4(d).

In consequence of the aforementioned heat treatment of semiconductor substrate 1, the first conductivity type dopant diffuses into the surface of semiconductor substrate 1 from first conductivity type dopant diffusing agent 3 through thin film portions 2c of diffusion suppressing mask 2 so that high-concentration first conductivity type dopant diffusion layer 5 is formed, and the first conductivity type dopant diffuses into the surface of semiconductor substrate 1 from first conductivity type dopant diffusing agent 3 through thick film portions 2a of diffusion suppressing mask 2 so that low-concentration first conductivity type dopant diffusion layers 16 are formed.

In consequence of the aforementioned heat treatment of semiconductor substrate 1, further, the second conductivity type dopant diffuses into the surface of semiconductor substrate 1 from second conductivity type dopant diffusing agent 4 through thin film portions 2c of diffusion suppressing mask 2 so that high-concentration second conductivity type dopant diffusion layer 6 is formed, and the second conductivity type dopant diffuses into the surface of semiconductor substrate 1 from second conductivity type dopant diffusing agent 4 through thick film portions 2a of diffusion suppressing mask 2 so that low-concentration second conductivity type dopant diffusion layers 17 are formed.

In other words, the first conductivity type dopant and the second conductivity type dopant diffuse from first conductivity type dopant diffusing agent 3 and second conductivity type dopant diffusing agent 4 respectively through diffusion suppressing mask 2 having thin film portions 2c and thick film portions 2a having a larger film thickness than thin film portions 2c also in this case, whereby the quantities of the dopants passing through thin film portions 2c and diffusing into the surface of semiconductor substrate 1 are rendered larger than the quantities of the dopants diffusing into the surface of semiconductor substrate 1 through thick film portions 2a.

Thus, it follows that the high-concentration dopant diffusion layers (high-concentration first conductivity type dopant diffusion layer 5 and high-concentration second conductivity type dopant diffusion layer 6) are formed on surface regions of semiconductor substrate 1 corresponding to thin film portions 2c of diffusion suppressing mask 2 while the low-concentration dopant diffusion layers (low-concentration first conductivity type dopant diffusion layers 16 and low-concentration second conductivity type dopant diffusion layers 17) are formed on surface regions of semiconductor substrate 1 corresponding to thick film portions 2a of diffusion suppressing mask 2 also in this embodiment.

Then, diffusion suppressing mask 2, first conductivity type dopant diffusing agent 3 and second conductivity type dopant diffusing agent 4 are removed from the surface of semiconductor substrate 1 thereby exposing the surfaces of high-concentration first conductivity type dopant diffusion layer 5, high-concentration second conductivity type dopant diffusion layer 6, low-concentration first conductivity type dopant diffusion layers 16 and low-concentration second conductivity type dopant diffusion layers 17 on the surface of semiconductor substrate 1, as shown in Fig. 4(e).

Then, a passivation film 7 is formed on the surface of semiconductor substrate 1 on the side where high-concentration first conductivity type dopant diffusion layer 5, high-concentration second conductivity type dopant diffusion layer 6, low-concentration first conductivity type dopant diffusion layers 16 and low-concentration second conductivity type dopant diffusion layers 17 are exposed, as shown in Fig. 4(f).

Then, a textured structure 8 consisting of pyramidal irregularities, for example, is formed on the surface of semiconductor substrate 1 opposite to the side provided with passivation film 7, as shown in Fig. 4(g).

Then, a reflection preventing film 9 is formed on textured structure 8 on the surface of semiconductor substrate 1, as shown in Fig. 4(h).

Then, contact holes are formed by partially removing passivation film 7 from semiconductor substrate 1, for exposing the surfaces of the respective ones of high-concentration first conductivity type dopant diffusion layer 5 and high-concentration second conductivity type dopant diffusion layer 6 from the contact holes, as shown in Fig. 4(i).

Then, a first conductivity type electrode 10 electrically connected to high-concentration first conductivity type dopant diffusion layer 5 and a second conductivity type electrode 11 electrically connected to second conductivity type dopant diffusion layer 6 are formed through the contact holes, as shown in Fig. 4(j).

Thus, a rear electrode type solar cell can be prepared by the solar cell producing method according to this embodiment.

Also in the solar cell producing method according to this embodiment which is an example of the present invention, it follows that the high-concentration dopant diffusion layers (high-concentration first conductivity type dopant diffusion layer 5 and high-concentration second conductivity type dopant diffusion layer 6) and the low-concentration dopant diffusion layers (low-concentration first conductivity type dopant diffusion layers 16 and low-concentration second conductivity type dopant diffusion layers 17) are formed on desired positions due to the setting of diffusion suppressing mask 2 having thin film portions 2c and thick film portions 2a and the dopant diffusing agents (first conductivity type dopant diffusing agent 3 and second conductivity type dopant diffusing agent 4).

Even if the dopants out-diffuse (externally diffuse) from the dopant diffusing agents in the heat treatment of semiconductor substrate 1, therefore, thick film portions 2a of diffusion suppressing mask 2 can effectively inhibit the out-diffusing dopants from diffusing into different portions of the surface of semiconductor substrate 1 also in the solar cell producing method according to this embodiment, whereby the high-concentration dopant diffusion layers and the low-concentration dopant diffusion layers can be stably formed on the desired positions, as compared with the method described in the aforementioned Patent Document 1.

Also in the solar cell producing method according to this embodiment, no steps of patterning diffusion suppressing mask 2 (forming thin film portions 2c of diffusion suppressing mask 2) for forming high-concentration first conductivity type dopant diffusion layer 5 and high-concentration second conductivity type dopant diffusion layer 6 may be carried out in the formation of high-concentration first conductivity type dopant diffusion layer 5 and in the formation of high-concentration second conductivity type dopant diffusion layer 6 (twice in total), whereby the producing steps can be simplified.

Also in the solar cell producing method according to this embodiment, further, the heat treatment for forming high-concentration first conductivity type dopant diffusion layer 5, high-concentration second conductivity type dopant diffusion layer 6, low-concentration first conductivity type dopant diffusion layers 16 and low-concentration second conductivity type dopant diffusion layers 17 may be carried out only once, whereby the producing steps can be simplified, and thermal damage of semiconductor substrate 1 etc. resulting from the heat treatment can be effectively suppressed.

Description of this embodiment other than the above is similar to those of the first embodiment and the second embodiment, and hence redundant description is not repeated.

### <Fourth Embodiment>

This embodiment is characterized in a point that diffusion of a first conductivity type dopant on the surface of a semiconductor substrate is performed by vapor phase diffusion with first conductivity type dopant-containing gas containing the first conductivity type dopant, in place of the application diffusion with the first conductivity type dopant diffusing agent.

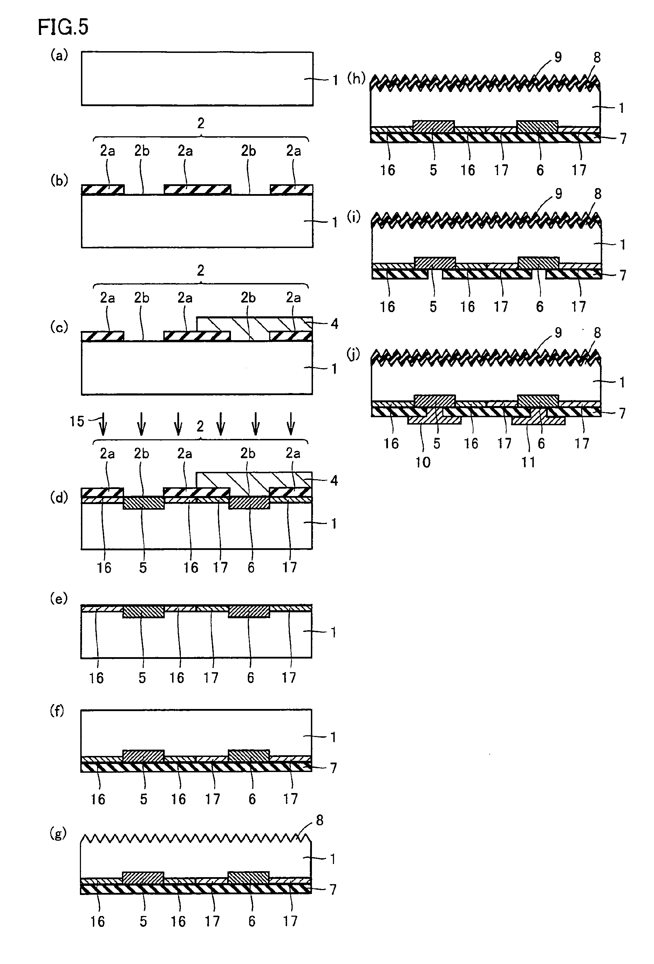

A solar cell producing method according to this embodiment is now described with reference to schematic sectional views of Fig. 5(a) to Fig. 5(j). While Fig. 5(a) to Fig. 5(j) also show the method as if only one high-concentration first conductivity type dopant diffusion layer 5 and only one high-concentration second conductivity type dopant diffusion layer 6 are formed on a semiconductor substrate 1 for the convenience of illustration, a plurality of high-concentration first conductivity type dopant diffusion layers 5 and a plurality of high-concentration second conductivity type dopant diffusion layers 6 may be formed in practice, as a matter of course.

First, semiconductor substrate 1 is prepared as shown in Fig. 5(a), and then a diffusion suppressing mask 2 having openings 2b and thick film portions 2a is then formed on part of the surface of semiconductor substrate 1, as shown in Fig. 5(b). Diffusion suppressing mask 2 can be formed by a method similar to those in the first to third embodiments.

Then, a second conductivity type dopant diffusing agent 4 containing a second conductivity type dopant is applied to cover part of diffusion suppressing mask 2 on the surface of semiconductor substrate 1, as shown in Fig. 5(c).

Then, semiconductor substrate 1 is heat-treated for forming low-concentration second conductivity type dopant diffusion layers 17 and high-concentration second conductivity type dopant diffusion layer 6 by diffusing the second conductivity type dopant into the surface of semiconductor substrate 1 from second conductivity type dopant diffusing agent 4 while first conductivity type dopant-containing gas 15 is so fed as to diffuse the first conductivity type dopant into the surface of semiconductor substrate 1 for forming low-concentration first conductivity type dopant diffusion layers 16 and high-concentration first conductivity type dopant diffusion layer 5, as shown in Fig. 5(d).

The step of diffusing the first conductivity type dopant employing first conductivity type dopant-containing gas 1 may be carried out in the same step as the step of diffusing the second conductivity type dopant, or may be continuously carried out immediately before and/or immediately after the step of diffusing the second conductivity type dopant.

In consequence of the aforementioned vapor phase diffusion employing first conductivity type dopant-containing gas 15, the first conductivity type dopant diffuses into the surface of semiconductor substrate 1 from first conductivity type dopant-containing gas 15 through openings 2b of diffusion suppressing mask 2 so that high-concentration first conductivity type dopant diffusion layer 5 is formed, and the first conductivity type dopant diffuses into the surface of semiconductor substrate 1 from first conductivity type dopant-containing gas 15 through thick film portions 2a of diffusion suppressing mask 2 so that low-concentration first conductivity type dopant diffusion layers 16 are formed.

In consequence of the aforementioned heat treatment of semiconductor substrate 1, further, the second conductivity type dopant diffuses into the surface of semiconductor substrate 1 from second conductivity type dopant diffusing agent 4 through openings 2b of diffusion suppressing mask 2 so that high-concentration second conductivity type dopant diffusion layer 6 is formed, and the second conductivity type dopant diffuses into the surface of semiconductor substrate 1 from second conductivity type dopant diffusing agent 4 through thick film portions 2a of diffusion suppressing mask 2 so that low-concentration second conductivity type dopant diffusion layers 17 are formed.

In other words, the first conductivity type dopant and the second conductivity type dopant diffuse from first conductivity type dopant-containing gas 15 and second conductivity type dopant diffusing agent 4 respectively through diffusion suppressing mask 2 having openings 2b and thick film portions 2a also in this case, whereby the quantities of the dopants diffusing into the surface of semiconductor substrate 1 through openings 2b are rendered larger than the quantities of the dopants diffusing into the surface of semiconductor substrate 1 through thick film portions 2a also in this case.

Thus, it follows that the high-concentration dopant diffusion layers (high-concentration first conductivity type dopant diffusion layer 5 and high-concentration second conductivity type dopant diffusion layer 6) are formed on surface regions of semiconductor substrate 1 corresponding to openings 2b of diffusion suppressing mask 2 while the low-concentration dopant diffusion layers (low-concentration first conductivity type dopant diffusion layers 16 and low-concentration second conductivity type dopant diffusion layers 17) are formed on surface regions of semiconductor substrate 1 corresponding to thick film portions 2a of diffusion suppressing mask 2 also in this embodiment.

As first conductivity type dopant-containing gas 15, gas containing a p-type dopant of boron or the like such as BBr₂, for example, can be employed if the first conductivity type is the p type, while gas containing an n-type dopant of phosphorus or the like such as POCl₃, for example, can be employed if the first conductivity type is the n type.

Then, diffusion suppressing mask 2 and second conductivity type dopant diffusing agent 4 are removed from the surface of semiconductor substrate 1 thereby exposing the surfaces of high-concentration first conductivity type dopant diffusion layer 5, high-concentration second conductivity type dopant diffusion layer 6, low-concentration first conductivity type dopant diffusion layers 16 and low-concentration second conductivity type dopant diffusion layers 17 on the surface of semiconductor substrate 1, as shown in Fig. 5(e).

Then, a passivation film 7 is formed on the surface of semiconductor substrate 1 on the side where high-concentration first conductivity type dopant diffusion layer 5, high-concentration second conductivity type dopant diffusion layer 6, low-concentration first conductivity type dopant diffusion layers 16 and low-concentration second conductivity type dopant diffusion layers 17 are exposed, as shown in Fig. 5(f).

Then, a textured structure 8 consisting of pyramidal irregularities, for example, is formed on the surface of semiconductor substrate 1 opposite to the side provided with passivation film 7, as shown in Fig. 5(g).

Then, a reflection preventing film 9 is formed on textured structure 8 on the surface of semiconductor substrate 1, as shown in Fig. 5(h).

Then, contact holes are formed by partially removing passivation film 7 from semiconductor substrate 1, for exposing the surfaces of the respective ones of high-concentration first conductivity type dopant diffusion layer 5 and high-concentration second conductivity type dopant diffusion layer 6 from the contact holes, as shown in Fig. 5(i).

Then, a first conductivity type electrode 10 electrically connected to high-concentration first conductivity type dopant diffusion layer 5 and a second conductivity type electrode 11 electrically connected to second conductivity type dopant diffusion layer 6 are formed through the contact holes, as shown in Fig. 5(j).

Thus, a rear electrode type solar cell can be prepared by the solar cell producing method according to this embodiment.

In the solar cell producing method according to this embodiment which is an example of the present invention, it follows that that the high-concentration dopant diffusion layers (high-concentration first conductivity type dopant diffusion layer 5 and high-concentration second conductivity type dopant diffusion layer 6) and the low-concentration dopant diffusion layers (low-concentration first conductivity type dopant diffusion layers 16 and low-concentration second conductivity type dopant diffusion layers 17) are formed on desired positions due to the setting of diffusion suppressing mask 2 having thick film portions 2a and openings 2b, the setting of the dopant diffusing agent (second conductivity type dopant diffusing agent 4) and the vapor phase diffusion employing first conductivity type dopant-containing gas 15.

Even if the dopant cut-diffuses (externally diffuses) from the dopant diffusing agent in the heat treatment of semiconductor substrate 1, therefore, thick film portions 2a of diffusion suppressing mask 2 can effectively inhibit the out-diffusing dopant from diffusing into different portions of the surface of semiconductor substrate 1 also in the solar cell producing method according to this embodiment, whereby the high-concentration dopant diffusion layers and the low-concentration dopant diffusion layers can be stably formed on the desired positions, as compared with the method described in the aforementioned Patent Document 1.

Also in the solar cell producing method according to this embodiment, the step of patterning diffusion suppressing mask 2 (forming openings 2b of diffusion suppressing mask 2) for forming high-concentration first conductivity type dopant diffusion layer 5 and high-concentration second conductivity type dopant diffusion layer 6 can be carried out only once, whereby the producing steps can be simplified.

Also in the solar cell producing method according to this embodiment, further, the heat treatment for forming high-concentration first conductivity type dopant diffusion layer 5, high-concentration second conductivity type dopant diffusion layer 6, low-concentration first conductivity type dopant diffusion layers 16 and low-concentration second conductivity type dopant diffusion layers 17 may be carried out only once, whereby the producing steps can be simplified, and thermal damage of semiconductor substrate 1 etc. resulting from the heat treatment can be effectively suppressed.

While the vapor phase diffusion of the first conductivity type dopant with first conductivity type dopant-containing gas 15 containing the first conductivity type dopant and the application diffusion of the second conductivity type dopant with second conductivity type dopant diffusing agent 4 are performed in this embodiment, vapor phase diffusion of the second conductivity type dopant with second conductivity type dopant-containing gas containing the second conductivity type dopant and application diffusion of the first conductivity type dopant with a first conductivity type dopant diffusing agent may be performed by replacing the first conductivity type and the second conductivity type with each other.

Description of this embodiment other than the above is similar to those of the first to third embodiments, and hence redundant description is not repeated.

### <Fifth Embodiment>

This embodiment is characterized in a point that a first conductivity type dopant diffusing agent 3 is applied to cover a diffusion suppressing mask 2 and a second conductivity type dopant diffusing agent 4 after application of second conductivity type dopant diffusing agent 4.

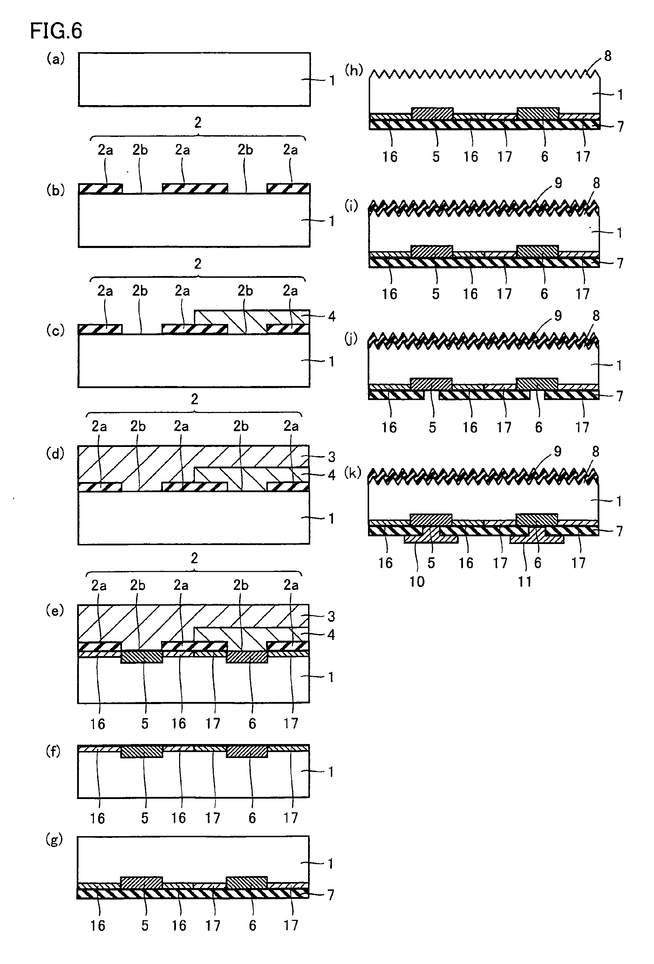

A solar cell producing method according to this embodiment is now described with reference to Fig. 6(a) to Fig. 6(k). While Fig. 6(a) to Fig. 6(k) also show the method as if only one high-concentration first conductivity type dopant diffusion layer 5 and only one high-concentration second conductivity type dopant diffusion layer 6 are formed on a semiconductor substrate 1 for the convenience of illustration, a plurality of high-concentration first conductivity type dopant diffusion layers 5 and a plurality of high-concentration second conductivity type dopant diffusion layers 6 may be formed in practice, as a matter of course.

First, semiconductor substrate 1 is prepared as shown in Fig. 6(a), and diffusion suppressing mask 2 having openings 2b and thick film portions 2a is then formed on part of the surface of semiconductor substrate 1, as shown in Fig. 6(b). Diffusion suppressing mask 2 can be formed by a method similar to those in the first to fourth embodiments.

Then, second conductivity type dopant diffusing agent 4 containing a second conductivity type dopant is applied to cover part of diffusion suppressing mask 2 on the surface of semiconductor substrate 1, as shown in Fig. 6(c).

Then, first conductivity type dopant diffusing agent 3 containing a first conductivity type dopant is applied to cover part of diffusion suppressing mask 2 and second conductivity type dopant diffusing agent 4 on the surface of semiconductor substrate 1, as shown in Fig. 6(d).

Then, semiconductor substrate 1 is heat-treated for forming low-concentration first conductivity type dopant diffusion layers 16, high-concentration first conductivity type dopant diffusion layer 5, low-concentration second conductivity type dopant diffusion layers 17 and high-concentration second conductivity type dopant diffusion layer 7 by diffusing the first conductivity type dopant and the second conductivity type dopant into the surface of semiconductor substrate 1 from first conductivity type dopant diffusing agent 3 and second conductivity type dopant diffusing agent 4 respectively, as shown in Fig. 6(e).

In consequence of the aforementioned heat treatment of semiconductor substrate 1, the first conductivity type dopant diffuses into the surface of semiconductor substrate 1 from first conductivity type dopant diffusing agent 3 through openings 2b of diffusion suppressing mask 2 so that high-concentration first conductivity type dopant diffusion layer 5 is formed, and the first conductivity type dopant diffuses into the surface of semiconductor substrate 1 from first conductivity type dopant diffusing agent 3 through thick film portions 2a of diffusion suppressing mask 2 so that low-concentration first conductivity type dopant diffusion layers 16 are formed.

In consequence of the aforementioned heat treatment of semiconductor substrate 1, further, the second conductivity type dopant diffuses into the surface of semiconductor substrate 1 from second conductivity type dopant diffusing agent 4 through openings 2b of diffusion suppressing mask 2 so that high-concentration second conductivity type dopant diffusion layer 6 is formed, and the second conductivity type dopant diffuses into the surface of semiconductor substrate 1 from second conductivity type dopant diffusing agent 4 through thick film portions 2a of diffusion suppressing mask 2 so that low-concentration second conductivity type dopant diffusion layers 17 are formed.

In other words, the first conductivity type dopant and the second conductivity type diffuse from first conductivity type dopant diffusing agent 3 and second conductivity type dopant diffusing agent 4 respectively through diffusion suppressing mask 2 having openings 2b and thick film portions 2a also in this case, whereby the quantities of the dopants passing through openings 2b and diffusing into the surface of semiconductor substrate 1 are rendered larger than the quantities of the dopants diffusing into the surface of semiconductor substrate 1 through thick film portions 2a.

Thus, it follows that the high-concentration dopant diffusion layers (high-concentration first conductivity type dopant diffusion layer 5 and high-concentration second conductivity type dopant diffusion layer 6) are formed on surface regions of semiconductor substrate 1 corresponding to openings 2b of diffusion suppressing mask 2 while the low-concentration dopant diffusion layers (low-concentration first conductivity type dopant diffusion layers 16 and low-concentration second conductivity type dopant diffusion layers 17) are formed on surface regions of semiconductor substrate 1 corresponding to thick film portions 2a of diffusion suppressing mask 2 also in this embodiment.

Then, diffusion suppressing mask 2, first conductivity type dopant diffusing agent 3 and second conductivity type dopant diffusing agent 4 are removed from the surface of semiconductor substrate 1 thereby exposing the surfaces of high-concentration first conductivity type dopant diffusion layer 5, high-concentration second conductivity type dopant diffusion layer 6, low-concentration first conductivity type dopant diffusion layers 16 and low-concentration second conductivity type dopant diffusion layers 17 on the surface of semiconductor substrate 1, as shown in Fig. 6(f).

Then, a passivation film 7 is formed on the surface of semiconductor substrate 1 on the side where high-concentration first conductivity type dopant diffusion layer 5, high-concentration second conductivity type dopant diffusion layer 6, low-concentration first conductivity type dopant diffusion layers 16 and low-concentration second conductivity type dopant diffusion layers 17 are exposed, as shown in Fig. 6(g).

Then, a textured structure 8 consisting of pyramidal irregularities, for example, is formed on the surface of semiconductor substrate 1 opposite to the side provided with passivation film 7, as shown in Fig. 6(h).

Then, a reflection preventing film 9 is formed on textured structure 8 on the surface of semiconductor substrate 1, as shown in Fig. 6(i).

Then, contact holes are formed by partially removing passivation film 7 from semiconductor substrate 1, for exposing the surfaces of the respective ones of high-concentration first conductivity type dopant diffusion layer 5 and high-concentration second conductivity type dopant diffusion layer 6 from the contact holes, as shown in Fig. 6(j).

Then, a first conductivity type electrode 10 electrically connected to high-concentration first conductivity type dopant diffusion layer 5 and a second conductivity type electrode 11 electrically connected to second conductivity type dopant diffusion layer 6 are formed through the contact holes, as shown in Fig. 6(k).

Thus, a rear electrode type solar cell can be prepared by the solar cell producing method according to this embodiment.

In the solar cell producing method according to this embodiment which is an example of the present invention, it follows that the high-concentration dopant diffusion layers (high-concentration first conductivity type dopant diffusion layer 5 and high-concentration second conductivity type dopant diffusion layer 6) and the low-concentration dopant diffusion layers (low-concentration first conductivity type dopant diffusion layers 16 and low-concentration second conductivity type dopant diffusion layers 17) are formed on desired positions due to the setting of diffusion suppressing mask 2 having openings 2b and thick film portions 2a and the dopant diffusing agents (first conductivity type dopant diffusing agent 3 and second conductivity type dopant diffusing agent 4).

Also in the solar cell producing method according to this embodiment, no steps of patterning diffusion suppressing mask 2 (forming opening 2b of diffusion suppressing mask 2) for forming high-concentration first conductivity type dopant diffusion layer 5 and high-concentration second conductivity type dopant diffusion layer 6 may be carried out as to the respective ones of high-concentration first conductivity type dopant diffusion layer 5 and high-concentration second conductivity type dopant diffusion layer 6 (twice in total), whereby the producing steps can be simplified.

Also in the solar cell producing method according to this embodiment, further, the heat treatment for forming high-concentration first conductivity type dopant diffusion layer 5, high-concentration second conductivity type dopant diffusion layer 6, low-concentration first conductivity type dopant diffusion layers 16 and low-concentration second conductivity type dopant diffusion layers 17 may be carried out only once, whereby the producing steps can be simplified, and thermal damage of semiconductor substrate 1 etc. resulting from the heat treatment can be effectively suppressed.

While first conductivity type dopant diffusing agent 3 is applied to cover diffusion suppressing mask 2 and second conductivity type dopant diffusing agent 4 in this embodiment, second conductivity type dopant diffusing agent 4 may be applied to cover diffusion suppressing mask 2 and first conductivity type dopant diffusing agent 3 by replacing the first conductivity type and the second conductivity type with each other.

Description of this embodiment other than the above is similar to those of the first to fourth embodiments, and hence redundant description is not repeated.

### <Sixth Embodiment>

This embodiment is characterized in a point that not a rear electrode type solar cell but a solar cell having a structure including electrodes on a photoreceiving surface and a rear surface of a semiconductor substrate respectively is prepared.

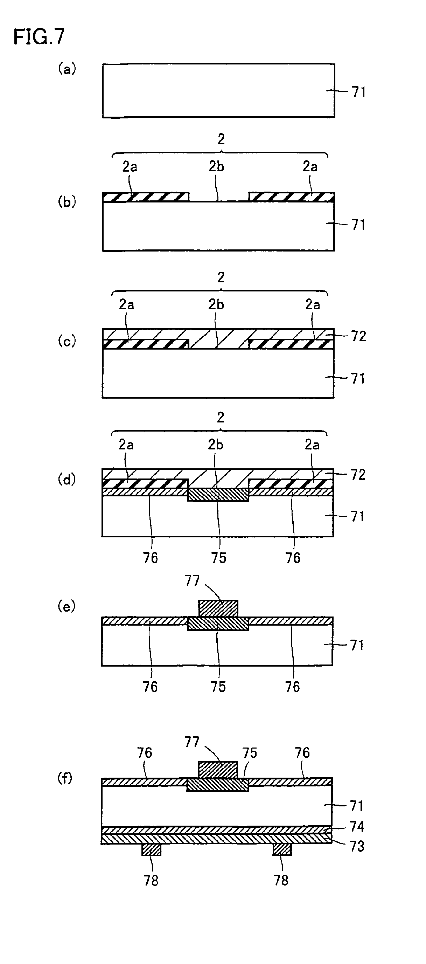

A solar cell producing method according to this embodiment is now described with reference to schematic sectional views of Fig. 7(a) to Fig. 7(f).

First, a p-type semiconductor substrate 71 is prepared as shown in Fig. 7(a), and a diffusion suppressing mask 2 having an opening 2b and thick film portions 2a is then formed on the surface of p-type semiconductor substrate 71, as shown in Fig. 7(b). Diffusion suppressing mask 2 can be formed similarly to the first to fifth embodiments.

Then, an n-type dopant diffusing agent 72 containing an n-type dopant such as phosphorus is applied to cover diffusion suppressing mask 2 on the surface of p-type semiconductor substrate 71, as shown in Fig. 7(c). As the method of applying n-type dopant diffusing agent 72, spray coating, coating employing a dispenser, ink jet printing, screen printing, letterpress printing, intaglio printing or flat plate printing can be employed, for example.

Then, p-type semiconductor substrate 71 is heat-treated for forming low-concentration n-type dopant diffusion layers 76 and a high-concentration n-type dopant diffusion layer 75 on the surface of p-type semiconductor substrate 71 by diffusing the n-type dopant into the surface of p-type semiconductor substrate 71 from n-type dopant diffusing agent 72, as shown in Fig. 7(d).

In consequence of the aforementioned heat treatment of p-type semiconductor substrate 71, the n-type dopant diffuses into the surface of p-type semiconductor substrate 71 from n-type dopant diffusing agent 72 through opening 2b of diffusion suppressing mask 2 so that high-concentration n-type dopant diffusion layer 75 is formed, and the n-type dopant diffuses into the surface of p-type semiconductor substrate 71 from n-type dopant diffusing agent 72 through thick film portions 2a of diffusion suppressing mask 2 so that low-concentration n-type dopant diffusion layers 76 are formed.

In other words, the n-type dopant diffuses from n-type dopant diffusing agent 72 through diffusion suppressing mask 2 having opening 2b and thick film portions 2a also in this case, whereby the quantity of the n-type dopant passing through opening 2b and diffusing into the surface of p-type semiconductor substrate 71 is rendered larger than the quantity of the dopant diffusing into the surface of p-type semiconductor substrate 71 through thick film portions 2a.

Thus, it follows that the high-concentration dopant diffusion layer (high-concentration n-type dopant diffusion layer 75) is formed on a surface region of p-type semiconductor substrate 71 corresponding to opening 2b of diffusion suppressing mask 2 and low-concentration dopant diffusion layers (low-concentration n-type dopant diffusion layers 76) are formed on surface regions of p-type semiconductor substrate 71 corresponding to thick film portions 2a of diffusion suppressing mask 2 also in this embodiment.

Then, diffusion suppressing mask 2 and n-type dopant diffusing agent 72 are removed from the surface of p-type semiconductor substrate 71 thereby exposing the surfaces of high-concentration n-type dopant diffusion layer 75 and low-concentration n-type dopant diffusion layers 76 on the surface of n-type semiconductor substrate 71, and an n electrode 77 is formed on the surface of high-concentration n-type dopant diffusion layer 75, as shown in Fig. 7(e).

Then, a p-type dopant diffusing agent 73 containing a p-type dopant such as aluminum is applied to the rear surface of p-type semiconductor substrate 71 opposite to the surface serving as a photoreceiving surface and p-type semiconductor substrate 71 is thereafter heat-treated for forming a p-type dopant diffusion layer 74 by diffusing the p-type dopant into the rear surface of p-type semiconductor substrate 71 from p-type dopant diffusing agent 73, as shown in Fig. 7(f). Then, a p electrode 78 is formed on p-type dopant diffusing agent 73 formed on the surface of p-type semiconductor substrate 71 serving as the rear electrode.

As the method of applying p-type dopant diffusing agent 73, spray coating, coating employing a dispenser, ink jet printing, screen printing, letterpress printing, intaglio printing or flat plate printing can be employed, for example.

As n electrode 77 and p electrode 78, electrodes made of metal such as silver can be employed, for example.

Thus, a solar cell having a structure including electrodes on a photoreceiving surface and a rear surface of a semiconductor substrate respectively can be prepared by the solar cell producing method according to this embodiment.

In the solar cell producing method according to this embodiment which is an example of the present invention, it follows that the high-concentration dopant diffusion layer (high-concentration n-type dopant diffusion layer 75) and the low-concentration dopant diffusion layers (low-concentration n-type dopant diffusion layers 76) are formed on desired positions due to the setting of diffusion suppressing mask 2 having opening 2b and thick film portions 2a and the dopant diffusing agent (n-type dopant diffusing agent 72).

In this embodiment, the conductivity types of the n type and the p type may be replaced with each other, and a reflection preventing film, a textured structure and a passivation film may be formed similarly to the first to fifth embodiments.

While Fig. 7(a) to Fig. 7(f) show the method as if only one high-concentration n-type dopant diffusion layer 75 is formed on p-type semiconductor substrate 71 for the convenience of illustration, a plurality of high-concentration n-type dopant diffusion layers 75 may be formed in practice, as a matter of course.

Description of this embodiment other than the above is similar to those of the first to fifth embodiments, and hence redundant description is not repeated.

### <Seventh Embodiment>

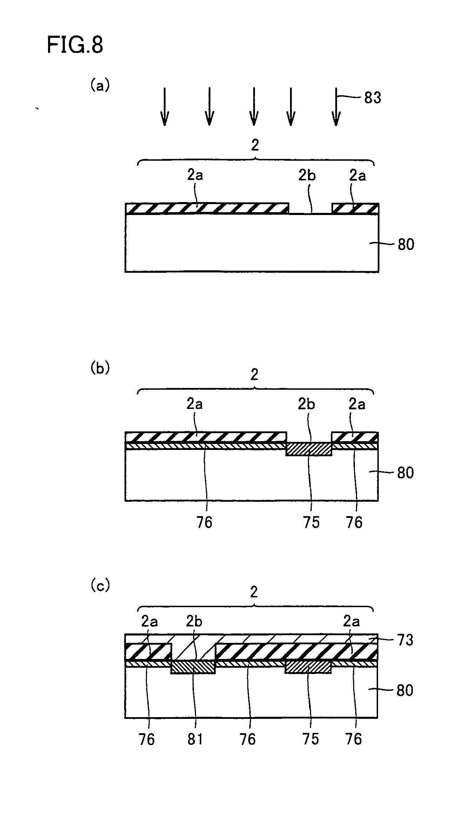

This embodiment is characterized in a point that a p-type dopant diffusion layer and n-type dopant diffusion layers are individually formed. A solar cell producing method according to this embodiment is now described with reference to schematic sectional views of Fig. 8(a) to Fig. 8(c).

First, an n-type silicon substrate 80 provided with a diffusion suppressing mask 2 having thick film portions 2a and an opening 2b on one surface is exposed to dopant gas 83 such as POCl₃ containing phosphorus, as shown in Fig. 8(a). At this time, n-type silicon substrate 80 can be exposed to dopant gas 83 containing phosphorus in a state heat-treated to a temperature of 850°C to 950°C, for example, for 20 minutes to 30 minutes, for example.

Thus, phosphorus diffuses into the surface of n-type silicon substrate 80 through opening 2b of diffusion suppressing mask 2 on n-type silicon substrate 80 so that a high-concentration n-type dopant diffusion layer 75 is formed and phosphorus diffuses into the surface of n-type silicon substrate 80 through thick film portions 2a of diffusion suppressing mask 2 so that low-concentration n-type dopant diffusion layers 76 are formed, as shown in Fig. 8(b).

In other words, phosphorus which is an n-type dopant diffuses through diffusion suppressing mask 2 having opening 2b and thick film portions 2a also in this case, whereby the quantity of phosphorus passing through opening 2b and diffusing into the surface of n-type silicon substrate 80 is rendered larger than the quantity of phosphorus diffusing into the surface of n-type silicon substrate 80 through thick film portions 2a.

Then, diffusion suppressing mask 2 formed on the surface of n-type silicon substrate 80 is temporarily entirely removed, thereafter another diffusion suppressing mask 2 having an opening 2b and thick film portions 2a is formed again, thereafter a p-type dopant diffusing agent 73 containing boron is applied to cover diffusion suppressing mask 2 and n-type silicon substrate 80 is thereafter heat treated so that a high-concentration p-type dopant diffusion layer 81 is formed, as shown in Fig. 8(c).

At this time, n-type silicon substrate 80 can be heated to a temperature of 950°C to 1000°C, for example, for 50 minutes, for example.

Boron diffuses into the surface of n-type silicon substrate 80 through opening 2b of diffusion suppressing mask 2 on n-type silicon substrate 80 so that high-concentration p-type diffusion layer 81 is formed, while diffusion of boron into the surface of n-type silicon substrate 80 is prevented by thick film portions 2a of diffusion suppressing mask 2. Thereafter a rear electrode type solar cell is prepared similarly to the first to fifth embodiments.

Description of this embodiment other than the above is similar to those of the first to fifth embodiments, and hence redundant description is not repeated.

### <Eighth Embodiment>

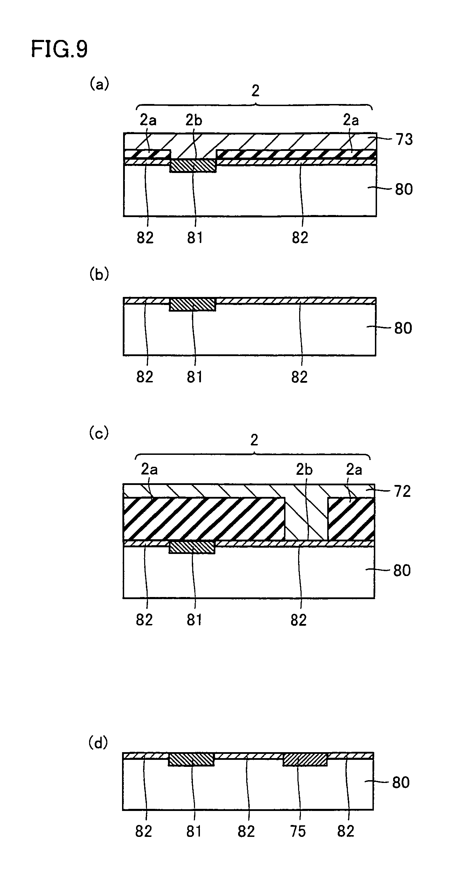

This embodiment is also characterized in a point that p-type dopant diffusion layers and an n-type dopant diffusion layer are individually formed. A solar cell producing method according to this embodiment is now described with reference to schematic sectional views of Fig. 9(a) to Fig. 9(d).

First, a p-type dopant diffusing agent 73 containing boron is applied to cover a diffusion suppressing mask 2 having thick film portions 2a and an opening 2b formed on one surface of an n-type silicon substrate 80 and n-type silicon substrate 80 is thereafter heat-treated for forming a high-concentration p-type dopant diffusion layer 81 and low-concentration p-type dopant diffusion layers 82 on the surface of n-type silicon substrate 80, as shown in Fig. 9(a). At this time, n-type silicon substrate 80 can be heated to a temperature of 950°C to 1000°C, for example, for 50 minutes, for example.

Boron diffuses into the surface of n-type silicon substrate 80 through opening 2b of diffusion suppressing mask 2 on n-type silicon substrate 80 so that high-concentration p-type dopant diffusion layer 81 is formed, while boron diffuses into the surface of n-type silicon substrate 80 through thick film portions 2a of diffusion suppressing mask 2 so that low-concentration p-type dopant diffusion layers 82 are formed.

In other words, boron which is a p-type dopant diffuses through diffusion suppressing mask 2 having opening 2b and thick film portions 2a also in this case, whereby the quantity of boron passing through opening 2b and diffusing into the surface of n-type silicon substrate 80 is rendered larger than the quantity of boron diffusing into the surface of n-type silicon substrate 80 through thick film portions 2a.

Then, diffusion suppressing mask 2 formed on the surface of n-type silicon substrate 80 is entirely removed, as shown in Fig. 9(b).

Then, another diffusion suppressing mask 2 having thick film portions 2a and an opening 2b is formed on the surface of n-type silicon substrate 80 and thereafter an n-type dopant diffusing agent 72 containing phosphorus is applied to cover diffusion suppressing mask 2, as shown in Fig. 9(c).

Thereafter n-type silicon substrate 80 is heat-treated to a temperature of 850°C to 950°C, for example, for 20 minutes to 30 minutes, for example, whereby phosphorus diffuses into the surface of n-type silicon substrate 80 through opening 2b of diffusion suppressing mask 2 on n-type silicon substrate 80 so that a high-concentration n-type dopant diffusion layer 75 is formed as shown in Fig. 9(d) while diffusion of phosphorus is prevented by thick film portions 2a of diffusion suppressing mask 2, and diffusion suppressing mask 2 and n-type dopant diffusing agent 72 are thereafter entirely removed. Thereafter a rear electrode type solar cell is prepared similarly to the first to fifth embodiments.

Description of this embodiment other than the above is similar to those of the first to fifth embodiments, and hence redundant description is not repeated.

### <Ninth Embodiment>

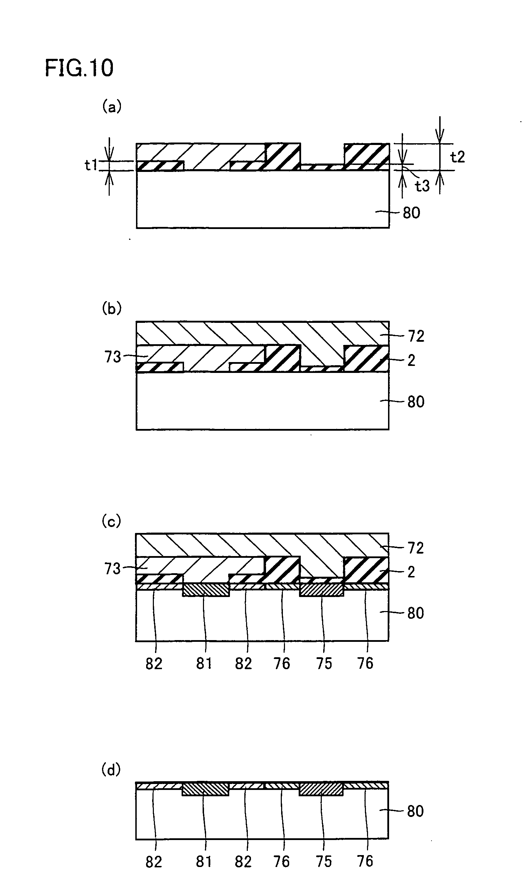

This embodiment is characterized in a point that a diffusion suppressing mask is formed to have various thicknesses. A solar cell producing method according to this embodiment is now described with reference to schematic sectional views of Fig. 10(a) to Fig. 10(d).

First, a diffusion suppressing mask 2 is formed on the surface of an n-type silicon substrate 80, as shown in Fig. 10(a). Diffusion suppressing mask 2 is constituted of portions having a thickness t1, an opening, portions having a thickness t2 and a portion having a thickness t3. The thickness t1, the thickness t2 and the thickness t3 are so set as to satisfy the relation of thickness t2 > thickness t1 > thickness t3.

The thickness t1 can be set to at least 100 nm and not more than 400 nm, for example, and more specifically, the same can be set to about 200 nm.

The thickness t2 can be set to at least 400 nm, for example, and more specifically, the same can be set to about 400 nm.

The thickness t3 can be set to at least 50 nm and not more than 250 nm, for example, and more specifically, the same can be set to about 100 nm.

Then, a p-type dopant diffusing agent 73 containing boron is applied and an n-type dopant diffusing agent 72 containing phosphorus is thereafter applied to cover p-type dopant diffusing agent 73 and diffusion suppressing mask 2, as shown in Fig. 10(b).

Then, n-type silicon substrate 80 is heat-treated for forming a high-concentration p-type dopant diffusion layer 81, low-concentration p-type dopant diffusion layers 82, a high-concentration n-type dopant diffusion layer 75 and low-concentration n-type dopant diffusion layers 76 on the surface of n-type silicon substrate 80, as shown in Fig. 10(c).

Boron diffuses into the surface of n-type silicon substrate 80 through the opening of diffusion suppressing mask 2 on n-type silicon substrate 80 so that high-concentration p-type dopant diffusion layer 81 is formed, while boron diffuses into the surface of n-type silicon substrate 80 through the portions of diffusion suppressing mask 2 having the thickness t1 so that low-concentration p-type dopant diffusion layers 82 are formed.

Further, phosphorus diffuses into the surface of n-type silicon substrate 80 through the portion of diffusion suppressing mask 2 on n-type silicon substrate 80 having the thickness t3 so that high-concentration n-type dopant diffusion layer 75 is formed, while phosphorus diffuses into the surface of n-type silicon substrate 80 through the portions of diffusion suppressing mask 2 having the thickness t2 so that low-concentration n-type dopant diffusion layers 76 are formed.

In other words, the quantity of boron passing through the opening of diffusion suppressing mask 2 and diffusing into the surface of n-type silicon substrate 80 is rendered larger than the quantity of boron diffusing into the surface of n-type silicon substrate 80 through the portions having the thickness t1 in this case.

Further, the quantity of phosphorus passing through the portion of diffusion suppressing mask 2 having the thickness t3 and diffusing into the surface of n-type silicon substrate 80 is rendered larger than the quantity of phosphorus diffusing into the surface of n-type silicon substrate 80 through the portions having the thickness t2.

In addition, phosphorus more easily deeply diffuses into n-type silicon substrate 80 than boron, whereby the depths of low-concentration n-type diffusion layers 76 resulting from the diffusion of phosphorus and low-concentration p-type dopant diffusion layers 82 resulting from the diffusion of boron can be rendered substantially equivalent to each other and the depths of high-concentration n-type dopant diffusion layer 75 resulting from the diffusion of phosphorus and high-concentration p-type dopant diffusion layer 81 resulting from the diffusion of boron can be rendered substantially equivalent to each other.

Description of this embodiment other than the above is similar to those of the first to fifth embodiments, and hence redundant description is not repeated.

### <Tenth Embodiment>

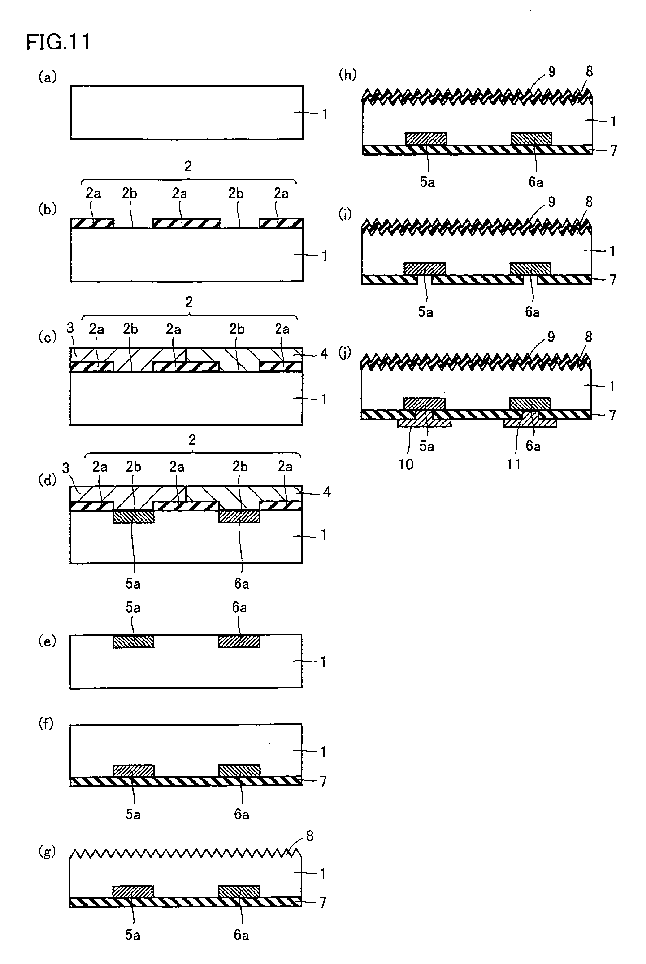

An example of a rear electrode type solar cell producing method which is an example of the semiconductor device producing method according to the present invention is now described with reference to schematic sectional views of Fig. 11(a) to Fig. 11(j).

First, a semiconductor substrate 1 is prepared, as shown in Fig. 11(a). While any substrate can be employed as semiconductor substrate 1 without particular restriction so far as the same is a substrate made of a semiconductor, a silicon substrate or the like obtained by slicing a silicon ingot can be employed, for example. The conductivity type of semiconductor substrate 1 is not particularly restricted either, and semiconductor substrate 1 may have n-type conductivity, may have p-type conductivity, or may have neither of the n-type conductivity and the p-type conductivity.

In a case of employing a silicon substrate as semiconductor substrate 1, a silicon substrate from which a slice damage caused by slicing a silicon ingot has been removed may be employed, for example. The aforementioned slice damage can be removed by etching the surface of the silicon substrate after the slicing with mixed acid of aqueous hydrogen fluoride and nitric acid or aqueous alkali such as sodium hydroxide, for example.

Semiconductor substrate 1 is not particularly restricted in size and shape, but can have such a quadrangular surface that the thickness is set to at least 100 µm and not more than 300 µm and the length of each side is set to at least 100 mm and not more than 200 mm, for example.

Then, a diffusion suppressing mask 2 is formed on one surface of semiconductor substrate 1, as shown in Fig. 11(b). Diffusion suppressing mask 2 is constituted of openings 2b having no film thickness and thick film portions 2a having a film thickness.

The film thickness of thick film portions 2a of diffusion suppressing mask 2 is not particularly restricted, so far as a first conductivity type dopant and a second conductivity type dopant do not reach the surface of semiconductor substrate 1 through thick film portions 2a.

Diffusion suppressing mask 2 (thick film portions 2a of diffusion suppressing mask 2 in this embodiment) can be formed by a method of applying masking paste having openings in portions corresponding to the portions for forming openings 2b to the surface of semiconductor substrate 1 and thereafter firing the masking paste, for example. As the method of applying the masking paste, spray coating, coating employing a dispenser, ink jet printing, screen printing, letterpress printing, intaglio printing or flat plate printing can be employed, for example.

As the masking paste, paste such as that containing a solvent, a thickener as well as a silicon oxide precursor and/or a titanium oxide precursor or the like can be employed, for example. Paste containing no thickener can also be employed as the masking paste.

As the solvent, one of or a combination of at least two of ethylene glycol, methyl cellosolve, methyl cellosolve acetate, ethyl cellosolve, diethyl cellosolve, cellosolve acetate, ethylene glycol monophenyl ether, methoxyethanol, ethylene glycol monoacetate, ethylene glycol diacetate, diethylene glycol, diethylene glycol monomethyl ether, diethylene glycol monoethyl ether acetate, diethylene glycol monobutyl ether, diethylene glycol monobutyl ether acetate, diethylene glycol dimethyl ether, diethylene glycol methyl ethyl ether, diethylene glycol diethyl ether, diethylene glycol acetate, triethyl glycol, triethylene glycol monomethyl ether, triethylene glycol monoethyl ether, tetraethylene glycol, liquid polyethylene glycol, propylene glycol, propylene glycol monomethyl ether, propylene glycol monoethyl ether, propylene glycol monobutyl ether, 1-butoxyethoxy propanol, dipropyl glycol, dipropylene glycol monomethyl ether, dipropylene glycol monoethyl ether, tripropylene glycol monomethyl ether, polypropylene glycol, trimethylene glycol, butanedial, 1,5-pentanedial, hexylene glycol, glycerin, gyceryl acetate, glycerin diacetate, glyceryl triacetate, trimethylol propine, 1,2,6-hexanetriol, 1,2-propanediol, 1,5-pentanediol, octanediol, 1,2-butanediol, 1,4-butanediol, 1,3-butanediol, dioxane, trioxane, tetrahydrofuran, tetrahydropyran, methylal, diethyl acetal, methyl ethyl ketone, methyl isobutyl ketone, diethyl ketone, acetonyl acetone, diacetone alcohol, methyl formate, ethyl formate, propyl formate, methyl acetate and ethyl acetate can be employed, for example.

While ethyl cellulose, polyvinyl pyrrolidone or a mixture thereof is desirably employed as the thickener, bentonites of various qualities and characteristics, a generally inorganic rheological additive for various polar solvent mixtures, nitrocellulose and other cellulose compounds, starch, gelatin, alginic acid, highly dispersive amorphous silicic acid (Aerosil (registered trademark)), polyvinyl butyral (Mowital (registered trademark)), sodium carboxymethyl cellulose (vivistar), thermoplastic polyamide resin (Eurelon (registered trademark)), an organic castor oil derivative (Thixin R (registered trademark)), diamide wax (Thixatrol plus (registered trademark)), swollen polyacrylate (Rheolate (registered trademark)), polyetherurea-polyurethane, polyether-polyol or the like can also be employed.

As the silicon oxide precursor, a substance such as TEOS (tetraethyl orthosilicate) expressed in a general formula R'ₙSi(OR)₄₋ₙ (R' represents methyl, ethyl or phenyl, R represents methyl, ethyl, n-propyl or i-propyl, and n represents 0, 1 or 2) can be employed, for example.

The titanium oxide precursor is a substance such as TPT (tetraisopropoxy titanium) expressed as R'ₙTi(OR)₄₋ₙ (R' represents methyl, ethyl or phenyl, R represents methyl, ethyl, n-propyl or 1-propyl, and n represents 0, 1 or 2) in addition to Ti(OH)₄, for example, and also includes TiCl₄, TiF₄, TiOSO₄ or the like.

Diffusion suppressing mask 2 (thick film portions 2a of diffusion suppressing mask 2 in this embodiment) can be formed by forming a single layer or a multilayer film of a silicon oxide film, a silicon nitride film, a titanium oxide film or an aluminum oxide film on the overall surface of semiconductor substrate 1 by CVD (Chemical Vapor Deposition) or the like and thereafter removing part of the film, for example. Part of the film made of the aforementioned material can be removed by a method of forming a resist pattern having openings in portions corresponding to the portions for forming openings 2b on the surface of the aforementioned film by photolithography and thereafter removing the aforementioned film from the openings of the resist pattern by etching or the like or a method of applying etching paste onto the diffusion suppressing mask corresponding to the portions for forming openings 2b and thereafter etching and removing the diffusion suppressing mask by heating, for example.

As the etching paste, that containing phosphoric acid as an etching component and containing water, an organic solvent and a thickener as components other than the etching component can be employed, for example. As the organic solvent, at least one of alcohol such as ethylene glycol, ether such as ethylene glycol monobutyl ether, ester such as propylene carbonate and ketone such as N-methyl-2-pyrrolidone can be employed, for example. As the thickener, at least one of cellulose, ethyl cellulose, a cellulose derivative, polyamide resin such as Nylon 6, a polymer such as polyvinyl pyrrolidone prepared by polymerizing a vinyl group and the like can be employed, for example.

Then, a first conductivity type dopant diffusing agent 3 containing a first conductivity type dopant and a second conductivity type dopant diffusing agent 4 containing a second conductivity type dopant are applied to cover diffusion suppressing mask 2 on the surface of semiconductor substrate 1, as shown in Fig. 11(c).

As the methods of applying first conductivity type dopant diffusing agent 3 and second conductivity type dopant diffusing agent 4, spray coating, coating employing a dispenser, ink jet printing, screen printing, letterpress printing, intaglio printing or flat plate printing can be employed, for example.

A material containing a first conductivity type dopant source can be employed as first conductivity type dopant diffusing agent 3, and as the first conductivity type dopant source, one of or a combination of at least two of phosphate, phosphorus oxide, diphosphorus pentaoxide, phosphoric acid and a compound such as an organic phosphorus compound containing phosphorus atoms, for example, can be employed if the first conductivity type is the n type, while one of or a combination of at least two of boron oxide, boric acid and compounds such as an organic boron compound, a boron-aluminum compound, an organic aluminum compound and aluminum salt containing boron atoms and/or aluminum atoms, for example, can be employed if the first conductivity type is the p type.

A material containing a second conductivity type dopant source can be employed as second conductivity type dopant diffusing agent 4, and as the second conductivity type dopant source, one of or a combination of at least two of boron oxide, boric acid and compounds such as an organic boron compound, a boron-aluminum compound, an organic aluminum compound and aluminum salt containing boron atoms and/or aluminum atoms, for example, can be employed if the second conductivity type is the p type, while one of or a combination of at least two of phosphate, phosphorus oxide, diphosphorus pentaoxide, phosphoric acid and a compound such as an organic phosphorus compound containing phosphorus atoms, for example, can be employed if the second conductivity type is the n type.

Each of first conductivity type dopant diffusing agent 3 and second conductivity type dopant diffusing agent 4 may contain a solvent and a thickener. As the solvent and the thickener contained in each of first conductivity type dopant diffusing agent 3 and second conductivity type dopant diffusing agent 4, one of or a combination of at least two of those described as the solvent and the thickener containable in the masking paste in the above can be employed, for example.

Then, semiconductor substrate 1 is heat-treated for forming a first conductivity type dopant diffusion layer 5a by diffusing the first conductivity type dopant into the surface of semiconductor substrate 1 from first conductivity type dopant diffusing agent 3 and forming a second conductivity type dopant diffusion layer 6a by diffusing the second conductivity type dopant into the surface of semiconductor substrate 1 from second conductivity type dopant diffusing agent 4, as shown in Fig. 11(d).

In consequence of the aforementioned heat treatment of semiconductor substrate 1, the first conductivity type dopant diffuses into the surface of semiconductor substrate 1 from first conductivity type dopant diffusing agent 3 through openings 2b of diffusion suppressing mask 2 so that first conductivity type dopant diffusion layer 5a is formed. On the other hand, the first conductivity type dopant does not diffuse into the surface of semiconductor substrate 1 from first conductivity type dopant diffusing agent 3 through thick film portions 2a of diffusion suppressing mask 2, and hence first conductivity type dopant diffusion layer 5a is not formed on surface regions (regions with which thick film portions 2a are in contact) of semiconductor substrate 1 corresponding to thick film portions 2a of diffusion suppressing mask 2.

Similarly in consequence of the aforementioned heat treatment of semiconductor substrate 1, the second conductivity type dopant diffuses into the surface of semiconductor substrate 1 from second conductivity type dopant diffusing agent 4 through openings 2b of diffusion suppressing mask 2 so that second conductivity type dopant diffusion layer 6a is formed. On the other hand, the second conductivity type dopant does not diffuse into the surface of semiconductor substrate 1 from second conductivity type dopant diffusing agent 4 through thick film portions 2a of diffusion suppressing mask 2, and hence second conductivity type dopant diffusion layer 6a is not formed on the surface regions (regions with which thick film portions 2a are in contact) of semiconductor substrate 1 corresponding to thick film portions 2a of diffusion suppressing mask 2.

While the conditions for the aforementioned heat treatment of semiconductor substrate 1 are not particularly restricted, semiconductor substrate 1 can be heated at a temperature of at least 850°C and not more than 1000°C, for example, for at least 20 minutes and not more than 50 minutes, for example, in order to stably form the dopant diffusion layers (first conductivity type dopant diffusion layer 5a and second conductivity type dopant diffusion layer 6a).

Then, diffusion suppressing mask 2, first conductivity type dopant diffusing agent 3 and second conductivity type dopant diffusing agent 4 are removed from the surface of semiconductor substrate 1, as shown in Fig. 11(e). Thus, it follows that the surfaces of first conductivity type dopant diffusion layer 5a and second conductivity type dopant diffusion layer 6a are exposed on the surface of semiconductor substrate 1.

Then, a passivation film 7 is formed on the surface of semiconductor substrate 1 on the side where first conductivity type dopant diffusion layer 5a and second conductivity type dopant diffusion layer 6a are exposed, as shown in Fig. 11(f).

As passivation film 7, a silicon oxide film, a silicon nitride film or a multilayer body of a silicon oxide film and a silicon nitride film formed by plasma CVD or the like can be employed, for example.

Then, a textured structure 8 consisting of pyramidal irregularities, for example, is formed on the surface of semiconductor substrate 1 opposite to the side provided with passivation film 7, as shown in Fig. 11(g).

Textured structure 8 can be formed by etching the surface of semiconductor substrate 1, for example. The surface of semiconductor substrate 1 can be etched by etching the surface of semiconductor substrate 1 with an etching solution prepared by heating a liquid obtained by adding isopropyl alcohol to aqueous alkali such as sodium hydroxide or potassium hydroxide, for example, to at least 70°C and not more than 80°C, for example, if semiconductor substrate 1 is formed by a silicon substrate.

Then, a reflection preventing film 9 is formed on textured structure 8 on the surface of semiconductor substrate 1, as shown in Fig. 11(h). For reflection preventing film 9, a silicon oxide film, a silicon nitride film or a multilayer body of a silicon oxide film and a silicon nitride film formed by plasma CVD or the like can be employed, for example.

Then, contact holes are formed by partially removing passivation film 7 from semiconductor substrate 1, for exposing the surfaces of the respective ones of first conductivity type dopant diffusion layer 5a and second conductivity type dopant diffusion layer 6a from the contact holes, as shown in Fig. 11(i).

The contact holes can be formed by a method of forming a resist pattern having openings in portions corresponding to the portions for forming the contact holes on passivation film 7 by photolithography and thereafter removing passivation film 7 from the openings of the resist pattern by etching or a method of applying etching paste to portions of passivation film 7 corresponding to the portions for forming the contact holes and thereafter etching and removing passivation film 7 by heating, for example. As the etching paste, that similar to the etching paste described in the above can be employed.

Then, a first conductivity type electrode 10 electrically connected to first conductivity type dopant diffusion layer 5a and a second conductivity type electrode 11 electrically connected to second conductivity type dopant diffusion layer 6a are formed through the contact holes, as shown in Fig. 11(j).

As first conductivity type electrode 10 and second conductivity type electrode 11, electrodes made of metal such as silver can be employed, for example.

Thus, a rear electrode type solar cell can be prepared by the rear electrode type solar cell producing method according to this embodiment.

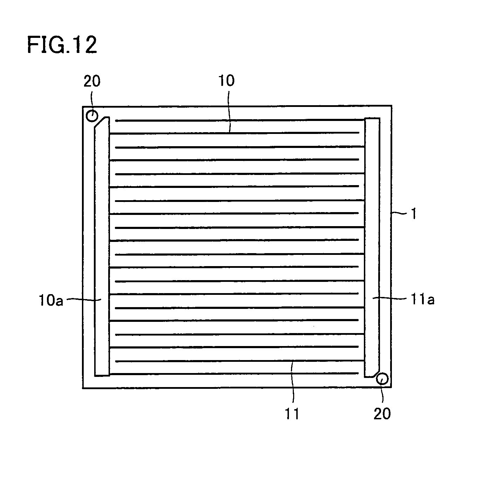

Fig. 12 is a schematic plan view of the rear surface of the rear electrode type solar cell prepared by the example of the rear electrode type solar cell producing method according to this embodiment which is the example of the semiconductor device producing method according to the present invention.

On the rear surface of the rear electrode type solar cell, a plurality of zonal first conductivity type electrodes 10 and a plurality of zonal second conductivity type electrodes 11 are alternately arranged one by one at intervals, while all first conductivity type electrodes 10 are electrically connected to one zonal first conductivity type collecting electrode 10a and all second conductivity type electrodes 11 are electrically connected to one zonal second conductivity type collecting electrode 11a, as shown in Fig. 12. On the rear surface of semiconductor substrate 1, two circular alignment marks 20 are arranged on diagonal corners of the rear surface of semiconductor substrate 1 respectively.

While it follows that first conductivity type dopant diffusion layer 5a is arranged under each of plurality of zonal first conductivity type electrodes 10 and second conductivity type dopant diffusion layer 6a is arranged under each of plurality of zonal second conductivity type electrodes 11 on the rear surface of semiconductor substrate 1, the shapes and the sizes of first conductivity type dopant diffusion layer 5a and second conductivity type dopant diffusion layer 6a are not particularly restricted. For example, first conductivity type dopant diffusion layer 5a and second conductivity type dopant diffusion layer 6a may be zonally formed along each of first conductivity type electrodes 10 and each of second conductivity type electrodes 11, or may be formed in the shape of dots in contact with part of each of first conductivity type electrodes 10 and each of second conductivity type electrodes 11.

While Fig. 11(a) to Fig. 11(j) show the method as if only one first conductivity type dopant diffusion layer 5a and only one second conductivity type dopant diffusion layer 6a are formed on semiconductor substrate 1 for the convenience of illustration, a plurality of first conductivity type dopant diffusion layers 5a and a plurality of second conductivity dopant diffusion layers 6a may be formed in practice, as a matter of course.

In the rear electrode type solar cell producing method according to this embodiment which is an example of the present invention, the presence or absence of diffusion of the dopants from the dopant diffusing agents can be controlled through the presence or absence of finely formed thick film portions 2a of diffusion suppressing mask 2, whereby the interval between first conductivity type dopant diffusion layer 5a and second conductivity type dopant diffusion layer 6a formed on the rear surface of semiconductor substrate 1 can be stably set to a prescribed small interval as compared with the method described in the aforementioned Patent Document 2.

In the rear electrode type solar cell producing method according to this embodiment, no steps of patterning diffusion suppressing mask 2 (forming openings 2b of diffusion suppressing mask 2) for forming first conductivity type dopant diffusion layer 5a and second conductivity type dopant diffusion layer 6a may be carried out in the formation of first conductivity type dopant diffusion layer 5a and in the formation of second conductivity type dopant diffusion layer 6a (twice in total), whereby the producing steps can be simplified.

In the rear electrode type solar cell producing method according to this embodiment, the heat treatment for forming first conductivity type dopant diffusion layer 5a and second conductivity type dopant diffusion layer 6a may be carried out only once, whereby the producing steps can be simplified, and thermal damage of semiconductor substrate 1 etc. resulting from the heat treatment can be effectively suppressed.

In the above, the first conductivity type may be either the n type or the p type, and the second conductivity type may simply be the conductivity type reverse to the first conductivity type. In other words, the second conductivity type is the p type when the first conductivity type is the n type, and the second conductivity type is the n type when the first conductivity type is the p type.

A p-type dopant such as boron or aluminum, for example, can be employed as the first conductivity type dopant if the first conductivity type is the p type, while an n-type dopant such as phosphorus, for example, can be employed as the first conductivity type dopant if the first conductivity type is the n type.

An n-type dopant such as phosphorus, for example, can be employed as the second conductivity type dopant if the second conductivity type is the n type, while a p-type dopant such as boron or aluminum, for example, can be employed as the second conductivity type dopant if the second conductivity type is the p type.

In order that the rear electrode type solar cell attains high characteristics, the dopant concentration in the dopant diffusion layers (first conductivity type dopant diffusion layer 5a and second conductivity type dopant diffusion layer 6a) is preferably set to at least 1 × 10¹⁹/cm³.

### <Eleventh Embodiment>

This embodiment is characterized in a point that a diffusion suppressing mask 2 is constituted of an opening 2b, a thin film portion 2c and thick film portions 2a having a larger film thickness than thin film portion 2c. The remaining points are similar to those of the tenth embodiment.

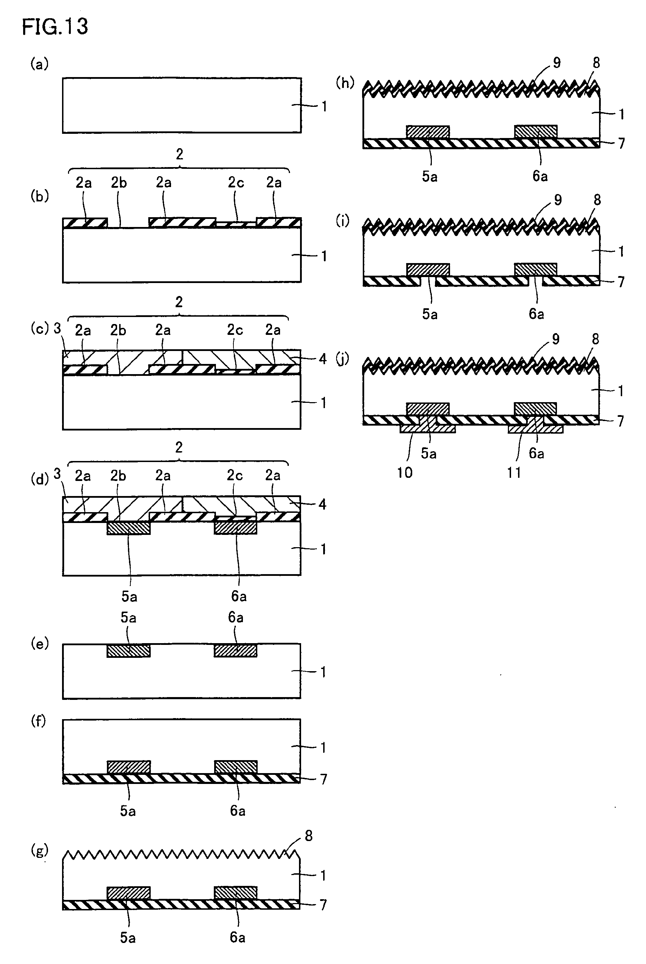

A rear electrode type solar cell producing method according to this embodiment is now described with reference to schematic sectional views of Fig. 13(a) to Fig. 13(j). While Fig. 13(a) to Fig. 13(j) also show the method as if only one first conductivity type dopant diffusion layer 5a and only one second conductivity type dopant diffusion layer 6a are formed on a semiconductor substrate 1 for the convenience of illustration, a plurality of first conductivity type dopant diffusion layers 5a and a plurality of second conductivity dopant diffusion layers 6a may be formed in practice, as a matter of course.

First, semiconductor substrate 1 is prepared as shown in Fig. 13(a), and diffusion suppressing mask 2 having opening 2b, thin film portion 2c and thick film portions 2a having a larger film thickness than thin film portion 2c is then formed on part of the surface of semiconductor substrate 1, as shown in Fig. 13(b). Diffusion suppressing mask 2 in this embodiment can be formed by a method similar to that for diffusion suppressing mask 2 in the tenth embodiment, for example. Thick film portions 2a and thin film portion 2c of diffusion suppressing mask 2 can be formed by applying masking paste in an overlapping manner by ink jet printing or the like thereby varying application thicknesses of the masking paste, for example.

The film thickness of thin film portion 2c of diffusion suppressing mask 2 is not particularly restricted, so far as a first conductivity type or second conductivity type dopant diffuses into the surface of semiconductor substrate 1 and dopant diffusion layers described later can be formed.

Then, a first conductivity type dopant diffusing agent 3 containing the first conductivity type dopant and a second conductivity type dopant diffusing agent 4 containing the second conductivity type dopant are applied to cover diffusion suppressing mask 2 on the surface of semiconductor substrate 1, as shown in Fig. 13(c). While first conductivity type dopant diffusing agent 3 is formed on a position corresponding to opening 2b of diffusion suppressing mask 2 and second conductivity type dopant diffusing agent 4 is formed on a position corresponding to thin film portion 2c of diffusion suppressing mask 2 in this embodiment, the present invention is not restricted to this structure, but the positions for forming first conductivity type dopant diffusing agent 3 and second conductivity type dopant diffusing agent 4 may be replaced with each other, for example.

First conductivity type dopant diffusing agent 3 and second conductivity type dopant diffusing agent 4 in this embodiment can be applied by a method similar to that for first conductivity type dopant diffusing agent 3 and second conductivity type dopant diffusing agent 4 in the tenth embodiment, for example.

Then, semiconductor substrate 1 is heat-treated for forming first conductivity type dopant diffusion layer 5a and second conductivity type dopant diffusion layer 6a by diffusing the first conductivity type dopant and the second conductivity type dopant into the surface of semiconductor substrate 1 from first conductivity type dopant diffusing agent 3 and second conductivity type dopant diffusing agent 4 respectively, as shown in Fig. 13(d).

In consequence of the aforementioned heat treatment of semiconductor substrate 1, the first conductivity type dopant diffuses into the surface of semiconductor substrate 1 from first conductivity type dopant diffusing agent 3 through opening 2b of diffusion suppressing mask 2 so that first conductivity type dopant diffusion layer 5a is formed. On the other hand, the first conductivity type dopant does not diffuse into the surface of semiconductor substrate 1 from first conductivity type dopant diffusing agent 3 through thick film portions 2a of diffusion suppressing mask 2, and hence first conductivity type dopant diffusion layer 5a is not formed on surface regions (regions with which thick film portions 2a are in contact) of semiconductor substrate 1 corresponding to thick film portions 2a of diffusion suppressing mask 2.

Similarly in consequence of the aforementioned heat treatment of semiconductor substrate 1, the second conductivity type dopant diffuses into the surface of semiconductor substrate 1 from second conductivity type dopant diffusing agent 4 through thin film portion 2c of diffusion suppressing mask 2 so that second conductivity type dopant diffusion layer 6a is formed. On the other hand, the second conductivity type dopant does not diffuse into the surface of semiconductor substrate 1 from second conductivity type dopant diffusing agent 4 through thick film portions 2a of diffusion suppressing mask 2, and hence second conductivity type dopant diffusion layer 6a is not formed on the surface regions (regions with which thick film portions 2a are in contact) of semiconductor substrate 1 corresponding to thick film portions 2a of diffusion suppressing mask 2.

Then, diffusion suppressing mask 2, first conductivity type dopant diffusing agent 3 and second conductivity type dopant diffusing agent 4 are removed from the surface of semiconductor substrate 1 thereby exposing the surfaces of first conductivity type dopant diffusion layer 5a and second conductivity type dopant diffusion layer 6a on the surface of semiconductor substrate 1, as shown in Fig. 13(e).

Then, a passivation film 7 is formed on the surface of semiconductor substrate 1 on the side where first conductivity type dopant diffusion layer 5a and second conductivity type dopant diffusion layer 6a are exposed, as shown in Fig. 13(f).

Then, a textured structure 8 consisting of pyramidal irregularities, for example, is formed on the surface of semiconductor substrate 1 opposite to the side provided with passivation film 7, as shown in Fig. 13(g).

Then, a reflection preventing film 9 is formed on textured structure 8 on the surface of semiconductor substrate 1, as shown in Fig. 13(h).

Then, contact holes are formed by partially removing passivation film 7 from semiconductor substrate 1, for exposing the surfaces of the respective ones of first conductivity type dopant diffusion layer 5a and second conductivity type dopant diffusion layer 6a from the contact holes, as shown in Fig. 13(i).

Then, a first conductivity type electrode 10 electrically connected to first conductivity type dopant diffusion layer 5a and a second conductivity type electrode 11 electrically connected to second conductivity type dopant diffusion layer 6a are formed through the contact holes, as shown in Fig. 13(j).

Thus, a rear electrode type solar cell can be prepared by the rear electrode type solar cell producing method according to this embodiment.

In the rear electrode type solar cell producing method according to this embodiment which is an example of the present invention, the presence or absence of diffusion of the dopants from the dopant diffusing agents can be controlled through the presence or absence of finely formed thick film portions 2a of diffusion suppressing mask 2, whereby the interval between first conductivity type dopant diffusion layer 5a and second conductivity type dopant diffusion layer 6a formed on the rear surface of semiconductor substrate 1 can be stably set to a prescribed small interval as compared with the method described in the aforementioned Patent Document 2.

In the rear electrode type solar cell producing method according to this embodiment, no steps of patterning diffusion suppressing mask 2 (forming opening 2b and thin film portion 2c of diffusion suppressing mask 2) for forming first conductivity type dopant diffusion layer 5a and second conductivity type dopant diffusion layer 6a may be carried out in the formation of first conductivity type dopant diffusion layer 5a and in the formation of second conductivity type dopant diffusion layer 6a (twice in total), whereby the producing steps can be simplified.

In the rear electrode type solar cell producing method according to this embodiment, the heat treatment for forming first conductivity type dopant diffusion layer 5a and second conductivity type dopant diffusion layer 6a may be carried out only once, whereby the producing steps can be simplified, and thermal damage of semiconductor substrate 1 etc. resulting from the heat treatment can be effectively suppressed.

Even if the diffusion coefficient of the first conductivity type dopant and the diffusion coefficient of the second conductivity type dopant with respect to semiconductor substrate 1 are remarkably different from each other, diffusion of the dopants can be adjusted by thin film portion 2c in the rear electrode type solar cell producing method according to this embodiment, whereby doping profiles (dopant concentration distribution) of first conductivity type dopant diffusion layer 5a and second conductivity type dopant diffusion layer 6a can be rendered more suitable.

Description of this embodiment other than the above is similar to that of the tenth embodiment, and hence redundant description is not repeated.

### <Twelfth Embodiment>

This embodiment is characterized in a point that a diffusion suppressing mask 2 is constituted of thin film portions 2c and thick film portions 2a having a larger film thickness than thin film portions 2c.

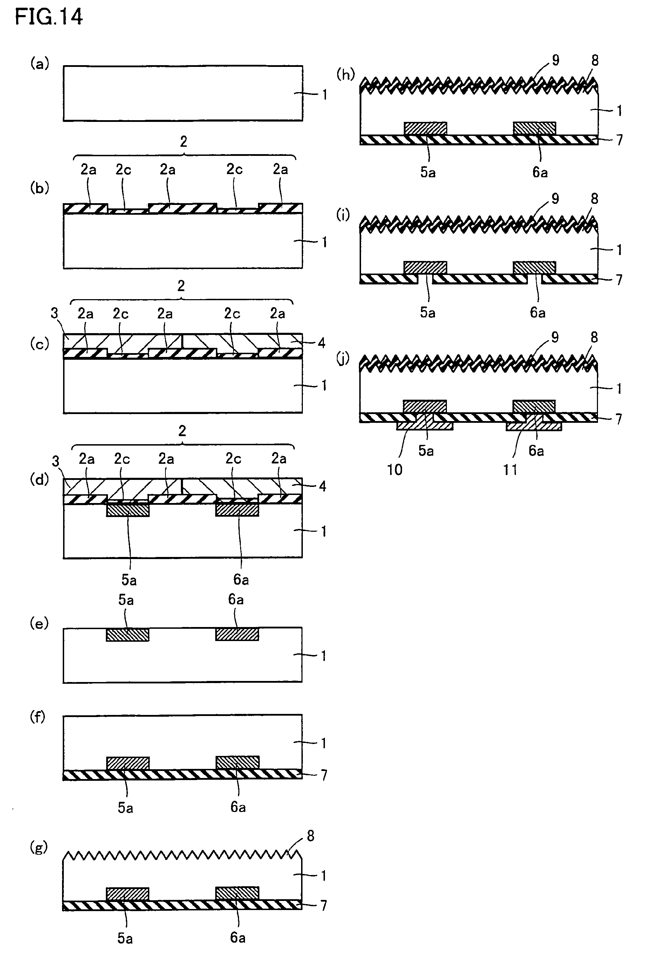

A rear electrode type solar cell producing method according to this embodiment is now described with reference to Fig. 14(a) to Fig. 14(j). While Fig. 14(a) to Fig. 14(j) also show the method as if only one first conductivity type dopant diffusion layer 5a and only one second conductivity type dopant diffusion layer 6a are formed on a semiconductor substrate 1 for the convenience of illustration, a plurality of first conductivity type dopant diffusion layers 5a and a plurality of second conductivity dopant diffusion layers 6a may be formed in practice, as a matter of course.

First, semiconductor substrate 1 is prepared as shown in Fig. 14(a), and diffusion suppressing mask 2 having thin film portions 2c and thick film portions 2a having a larger film thickness than thin film portions 2c is then formed on part of the surface of semiconductor substrate 1, as shown in Fig. 14(b). Diffusion suppressing mask 2 in this embodiment can be formed by a method similar to those for diffusion suppressing masks 2 in the tenth embodiment and the eleventh embodiment, for example.

Then, a first conductivity type dopant diffusing agent 3 containing the first conductivity type dopant and a second conductivity type dopant diffusing agent 4 containing the second conductivity type dopant are applied to cover diffusion suppressing mask 2 on the surface of semiconductor substrate 1, as shown in Fig. 14(c). First conductivity type dopant diffusing agent 3 and second conductivity type dopant diffusing agent 4 in this embodiment can be applied by a method similar to those for first conductivity type dopant diffusing agents 3 and second conductivity type dopant diffusing agents 4 in the tenth embodiment and the eleventh embodiment, for example.

Then, semiconductor substrate 1 is heat-treated for forming first conductivity type dopant diffusion layer 5a and second conductivity type dopant diffusion layer 6a by diffusing the first conductivity type dopant and the second conductivity type dopant into the surface of semiconductor substrate 1 from first conductivity type dopant diffusing agent 3 and second conductivity type dopant diffusing agent 4 respectively, as shown in Fig. 14(d).

In consequence of the aforementioned heat treatment of semiconductor substrate 1, the first conductivity type dopant diffuses into the surface of semiconductor substrate 1 from first conductivity type dopant diffusing agent 3 through thin film portions 2c of diffusion suppressing mask 2 so that first conductivity type dopant diffusion layer 5a is formed. On the other hand, the first conductivity type dopant does not diffuse into the surface of semiconductor substrate 1 from first conductivity type dopant diffusing agent 3 through thick film portions 2a of diffusion suppressing mask 2, and hence first conductivity type dopant diffusion layer 5a is not formed on surface regions (regions with which thick film portions 2a are in contact) of semiconductor substrate 1 corresponding to thick film portions 2a of diffusion suppressing mask 2.

Similarly in consequence of the aforementioned heat treatment of semiconductor substrate 1, the second conductivity type dopant diffuses into the surface of semiconductor substrate 1 from second conductivity type dopant diffusing agent 4 through thin film portions 2c of diffusion suppressing mask 2 so that second conductivity type dopant diffusion layer 6a is formed. On the other hand, the second conductivity type dopant does not diffuse into the surface of semiconductor substrate 1 from second conductivity type dopant diffusing agent 4 through thick film portions 2a of diffusion suppressing mask 2, and hence second conductivity type dopant diffusion layer 6a is not formed on the surface regions (regions with which thick film portions 2a are in contact) of semiconductor substrate 1 corresponding to thick film portions 2a of diffusion suppressing mask 2.

Then, diffusion suppressing mask 2, first conductivity type dopant diffusing agent 3 and second conductivity type dopant diffusing agent 4 are removed from the surface of semiconductor substrate 1 thereby exposing the surfaces of first conductivity type dopant diffusion layer 5a and second conductivity type dopant diffusion layer 6a on the surface of semiconductor substrate 1, as shown in Fig. 14(e).

Then, a passivation film 7 is formed on the surface of semiconductor substrate 1 on the side where first conductivity type dopant diffusion layer 5a and second conductivity type dopant diffusion layer 6a are exposed, as shown in Fig. 14(f).

Then, a textured structure 8 consisting of pyramidal irregularities, for example, is formed on the surface of semiconductor substrate 1 opposite to the side provided with passivation film 7, as shown in Fig. 14(g).

Then, a reflection preventing film 9 is formed on textured structure 8 on the surface of semiconductor substrate 1, as shown in Fig. 14(h).

Then, contact holes are formed by partially removing passivation film 7 from semiconductor substrate 1, for exposing the surfaces of the respective ones of first conductivity type dopant diffusion layer 5a and second conductivity type dopant diffusion layer 6a from the contact holes, as shown in Fig. 14(i).

Then, a first conductivity type electrode 10 electrically connected to first conductivity type dopant diffusion layer 5a and a second conductivity type electrode 11 electrically connected to second conductivity type dopant diffusion layer 6a are formed through the contact holes, as shown in Fig. 14(j).

Thus, a rear electrode type solar cell can be prepared by the rear electrode type solar cell producing method according to this embodiment.

In the rear electrode type solar cell producing method according to this embodiment which is an example of the present invention, the presence or absence of diffusion of the dopants from the dopant diffusing agents can be controlled through the presence or absence of finely formed thick film portions 2a of diffusion suppressing mask 2, whereby the interval between first conductivity type dopant diffusion layer 5a and second conductivity type dopant diffusion layer 6a formed on the rear surface of semiconductor substrate 1 can be stably set to a prescribed small interval as compared with the method described in the aforementioned Patent Document 2.

In the rear electrode type solar cell producing method according to this embodiment, no steps of patterning diffusion suppressing mask 2 (forming thin film portions 2c of diffusion suppressing mask 2) for forming first conductivity type dopant diffusion layer 5a and second conductivity type dopant diffusion layer 6a may be carried out in the formation of first conductivity type dopant diffusion layer 5a and in the formation of second conductivity type dopant diffusion layer 6a (twice in total), whereby the producing steps can be simplified.

In the rear electrode type solar cell producing method according to this embodiment, the heat treatment for forming first conductivity type dopant diffusion layer 5a and second conductivity type dopant diffusion layer 6a may be carried out only once, whereby the producing steps can be simplified, and thermal damage of semiconductor substrate 1 etc. resulting from the heat treatment can be effectively suppressed.

Description of this embodiment other than the above is similar to those of the tenth embodiment and the eleventh embodiment, and hence redundant description is not repeated.

### <Thirteenth Embodiment>

This embodiment is characterized in a point that diffusion of a first conductivity type dopant on the surface of a semiconductor substrate is performed by vapor phase diffusion through first conductivity type dopant-containing gas containing the first conductivity type dopant in place of the application diffusion through the first conductivity type dopant diffusing agent.

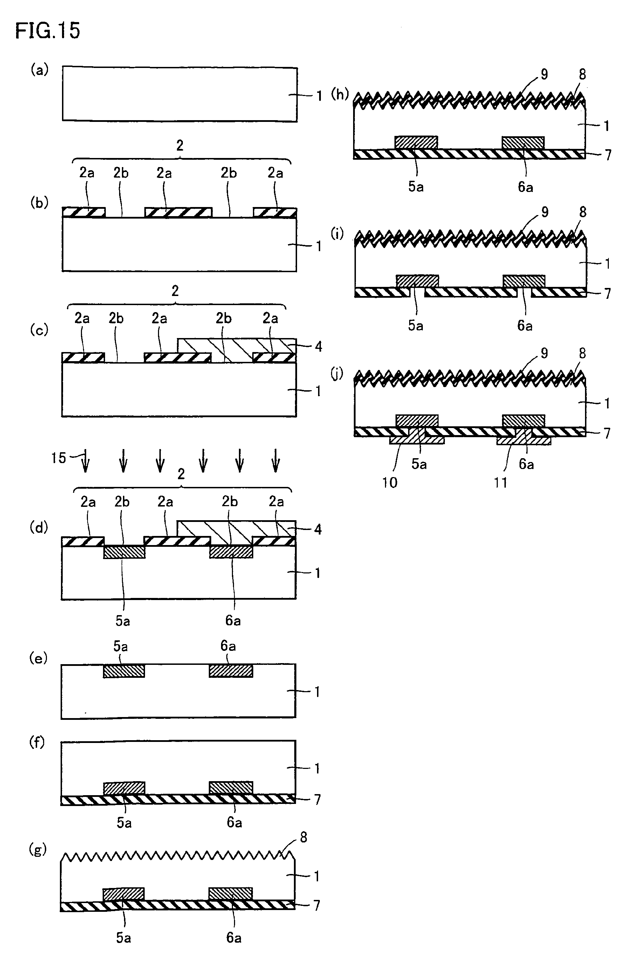

A rear electrode type solar cell producing method according to this embodiment is now described with reference to schematic sectional views of Fig. 15(a) to Fig. 15(j). While Fig. 15(a) to Fig. 15(j) also show the method as if only one first conductivity type dopant diffusion layer 5a and only one second conductivity type dopant diffusion layer 6a are formed on a semiconductor substrate 1 for the convenience of illustration, a plurality of first conductivity type dopant diffusion layers 5a and a plurality of second conductivity dopant diffusion layers 6a may be formed in practice, as a matter of course.

First, semiconductor substrate 1 is prepared as shown in Fig. 15(a), and a diffusion suppressing mask 2 having openings 2b and thick film portions 2a is then formed on part of the surface of semiconductor substrate 1, as shown in Fig. 15(b). Diffusion suppressing mask 2 can be formed by a method similar to those in the tenth to twelfth embodiments.

Then, a second conductivity type dopant diffusing agent 4 containing a second conductivity type dopant is applied to cover part of diffusion suppressing mask 2 on the surface of semiconductor substrate 1, as shown in Fig. 15(c).

Then, semiconductor substrate 1 is heat-treated for forming second conductivity type dopant diffusion layer 6a by diffusing the second conductivity type dopant into the surface of semiconductor substrate 1 from second conductivity type dopant diffusing agent 4 while first conductivity type dopant-containing gas 15 is fed for forming first conductivity type dopant diffusion layer 5a by diffusing the first conductivity type dopant into the surface of semiconductor substrate 1, as shown in Fig. 15(d).

The step of diffusing the first conductivity type dopant with first conductivity type dopant-containing gas 15 may be carried out in the same step as the step of diffusing the second conductivity type dopant, or may be continuously carried out immediately before and/or immediately after the step of diffusing the second conductivity type dopant.

In consequence of the aforementioned vapor phase diffusion employing first conductivity type dopant-containing gas 15, the first conductivity type dopant diffuses into the surface of semiconductor substrate 1 from first conductivity type dopant-containing gas 15 through openings 2b of diffusion suppressing mask 2 so that first conductivity type dopant diffusion layer 5a is formed. On the other hand, the first conductivity type dopant does not diffuse into the surface of semiconductor substrate 1 from first conductivity type dopant-containing gas 15 through thick film portions 2a of diffusion suppressing mask 2, and hence first conductivity type dopant diffusion layer 5a is not formed on surface regions (regions with which thick film portions 2a are in contact) of semiconductor substrate 1 corresponding to thick film portions 2a of diffusion suppressing mask 2.

Similarly in consequence of the aforementioned heat treatment of semiconductor substrate 1, the second conductivity type dopant diffuses into the surface of semiconductor substrate 1 from second conductivity type dopant diffusing agent 4 through openings 2b of diffusion suppressing mask 2 so that second conductivity type dopant diffusion layer 6a is formed. On the other hand, the second conductivity type dopant does not diffuse into the surface of semiconductor substrate 1 from second conductivity type dopant diffusing agent 4 through thick film portions 2a of diffusion suppressing mask 2, and hence second conductivity type dopant diffusion layer 6a is not formed on the surface regions (regions with which thick film portions 2a are in contact) of semiconductor substrate 1 corresponding to thick film portions 2a of diffusion suppressing mask 2.

As first conductivity type dopant-containing gas 15, gas containing a p-type dopant of boron or the like such as BBr₃, for example, can be employed if the first conductivity type is the p type, while gas containing an n-type dopant of phosphorus or the like such as POCl₃, for example, can be employed if the first conductivity type is the n type.

Then, diffusion suppressing mask 2 and second conductivity type dopant diffusing agent 4 are removed from the surface of semiconductor substrate 1 thereby exposing the surfaces of first conductivity type dopant diffusion layer 5a and second conductivity type dopant diffusion layer 6a on the surface of semiconductor substrate 1, as shown in Fig. 15(e).

Then, a passivation film 7 is formed on the surface of semiconductor substrate 1 on the side where first conductivity type dopant diffusion layer 5a and second conductivity type dopant diffusion layer 6a are exposed, as shown in Fig. 15(f).

Then, a textured structure 8 consisting of pyramidal irregularities, for example, is formed on the surface of semiconductor substrate 1 opposite to the side provided with passivation film 7, as shown in Fig. 15(g).

Then, a reflection preventing film 9 is formed on textured structure 8 on the surface of semiconductor substrate 1, as shown in Fig. 15(h).

Then, contact holes are formed by partially removing passivation film 7 from semiconductor substrate 1, for exposing the surfaces of the respective ones of first conductivity type dopant diffusion layer 5a and second conductivity type dopant diffusion layer 6a from the contact holes, as shown in Fig. 15(i).

Then, a first conductivity type electrode 10 electrically connected to high-concentration first conductivity type dopant diffusion layer 5a and a second conductivity type electrode 11 electrically connected to second conductivity type dopant diffusion layer 6a are formed through the contact holes, as shown in Fig. 15(j).

Thus, a rear electrode type solar cell can be prepared by the rear electrode type solar cell producing method according to this embodiment.

In the rear electrode type solar cell producing method according to this embodiment which is an example of the present invention, the presence or absence of diffusion of the dopants from the dopant-containing gas and the dopant diffusing agent can be controlled through the presence or absence of finely formed thick film portions 2a of diffusion suppressing mask 2, whereby the interval between first conductivity type dopant diffusion layer 5a and second conductivity type dopant diffusion layer 6a formed on the rear surface of semiconductor substrate 1 can be stably set to a prescribed small interval as compared with the method described in the aforementioned Patent Document 2.

In the rear electrode type solar cell producing method according to this embodiment, no steps of patterning diffusion suppressing mask 2 (forming openings 2b of diffusion suppressing mask 2) for forming first conductivity type dopant diffusion layer 5a and second conductivity type dopant diffusion layer 6a may be carried out in the formation of first conductivity type dopant diffusion layer 5a and in the formation of second conductivity type dopant diffusion layer 6a (twice in total), whereby the producing steps can be simplified.

In the rear electrode type solar cell producing method according to this embodiment, the heat treatment for forming first conductivity type dopant diffusion layer 5a and second conductivity type dopant diffusion layer 6a may be carried out only once, whereby the producing steps can be simplified, and thermal damage of semiconductor substrate 1 etc. resulting from the heat treatment can be effectively suppressed.

While the vapor phase diffusion of the first conductivity type dopant with first conductivity type dopant-containing gas 1 containing the first conductivity type dopant and the application diffusion of the second conductivity type dopant with second conductivity type dopant diffusing agent 4 in this embodiment, vapor phase diffusion of the second conductivity type dopant with second conductivity type dopant-containing gas containing the second conductivity type dopant and application diffusion of the first conductivity type dopant with a first conductivity type dopant diffusing agent may be performed by replacing the first conductivity type and the second conductivity type with each other.

Description of this embodiment other than the above is similar to those of the tenth to twelfth embodiments, and hence redundant description is not repeated.

### <Fourteenth Embodiment>

This embodiment is characterized in a point that a first conductivity type dopant diffusing agent 3 is applied to cover a diffusion suppressing mask 2 and a second conductivity type dopant diffusing agent 4 after application of second conductivity type dopant diffusing agent 4.

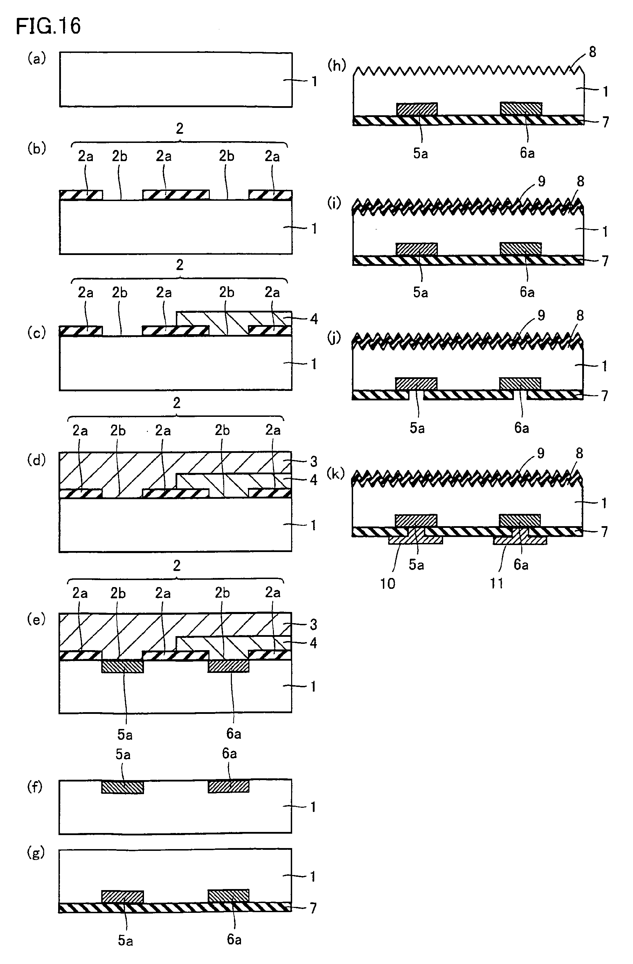

A rear electrode type solar cell producing method according to this embodiment is now described with reference to schematic sectional views of Fig. 16(a) to Fig. 16(k). While Fig. 16(a) to Fig. 16(k) also show the method as if only one first conductivity type dopant diffusion layer 5a and only one second conductivity type dopant diffusion layer 6a are formed on a semiconductor substrate 1 for the convenience of illustration, a plurality of first conductivity type dopant diffusion layers 5a and a plurality of second conductivity dopant diffusion layers 6a may be formed in practice, as a matter of course.

First, semiconductor substrate 1 is prepared as shown in Fig. 16(a), and diffusion suppressing mask 2 having openings 2b and thick film portions 2a is then formed on part of the surface of semiconductor substrate 1, as shown in Fig. 16(b). Diffusion suppressing mask 2 can be formed by a method similar to those in the tenth to thirteenth embodiments.

Then, second conductivity type dopant diffusing agent 4 containing the second conductivity type dopant is applied to cover part of diffusion suppressing mask 2 on the surface of semiconductor substrate 1, as shown in Fig. 16(c).

Then, first conductivity type dopant diffusing agent 3 containing the first conductivity type of dopant is applied to cover part of diffusion suppressing mask 2 and second conductivity type dopant diffusing agent 4 on the surface of semiconductor substrate 1, as shown in Fig. 16(d).

Then, semiconductor substrate 1 is heat-treated for forming first conductivity type dopant diffusion layer 5a and second conductivity type dopant diffusion layer 6a by diffusing the first conductivity type dopant and the second conductivity type dopant into the surface of semiconductor substrate 1 from first conductivity type dopant diffusing agent 3 and second conductivity type dopant diffusing agent 4 respectively, as shown in Fig. 16(e).

The first conductivity type dopant diffuses into the surface of semiconductor substrate 1 from first conductivity type dopant diffusing agent 3 through openings 2b of diffusion suppressing mask 2 so that first conductivity type dopant diffusion layer 5a is formed. On the other hand, the first conductivity type dopant does not diffuse into the surface of semiconductor substrate 1 from first conductivity type dopant diffusing agent 3 through thick film portions 2a of diffusion suppressing mask 2, and hence first conductivity type dopant diffusion layer 5a is not formed on surface regions (regions with which thick film portions 2a are in contact) of semiconductor substrate 1 corresponding to thick film portions 2a of diffusion suppressing mask 2.

Similarly in consequence of the aforementioned heat treatment of semiconductor substrate 1, the second conductivity type dopant diffuses into the surface of semiconductor substrate 1 from second conductivity type dopant diffusing agent 4 through openings 2b of diffusion suppressing mask 2 so that second conductivity type dopant diffusion layer 6a is formed. On the other hand, the second conductivity type dopant does not diffuse into the surface of semiconductor substrate 1 from second conductivity type dopant diffusing agent 4 through thick film portions 2a of diffusion suppressing mask 2, and hence second conductivity type dopant diffusion layer 6a is not formed on the surface regions (regions with which thick film portions 2a are in contact) of semiconductor substrate 1 corresponding to thick film portions 2a of diffusion suppressing mask 2.

Then, diffusion suppressing mask 2, first conductivity type dopant diffusing agent 3 and second conductivity type dopant diffusing agent 4 are removed from the surface of semiconductor substrate 1 thereby exposing the surfaces of first conductivity type dopant diffusion layer 5a and second conductivity type dopant diffusion layer 6a on the surface of semiconductor substrate 1, as shown in Fig. 16(f).

Then, a passivation film 7 is formed on the surface of semiconductor substrate 1 on the side where first conductivity type dopant diffusion layer 5a and second conductivity type dopant diffusion layer 6a are exposed, as shown in Fig. 16(g).

Then, a textured structure 8 consisting of pyramidal irregularities, for example, is formed on the surface of semiconductor substrate 1 opposite to the side provided with passivation film 7, as shown in Fig. 16(h).

Then, a reflection preventing film 9 is formed on textured structure 8 on the surface of semiconductor substrate 1, as shown in Fig. 16(i).

Then, contact holes are formed by partially removing passivation film 7 from semiconductor substrate 1, for exposing the surfaces of the respective ones of first conductivity type dopant diffusion layer 5a and second conductivity type dopant diffusion layer 6a from the contact holes, as shown in Fig. 16(j).

Then, a first conductivity type electrode 10 electrically connected to first conductivity type dopant diffusion layer 5a and a second conductivity type electrode 11 electrically connected to second conductivity type dopant diffusion layer 6a are formed through the contact holes, as shown in Fig. 16(k).

Thus, a rear electrode type solar cell can be prepared by the rear electrode type solar cell producing method according to this embodiment.

In the rear electrode type solar cell producing method according to this embodiment which is an example of the present invention, the presence or absence of diffusion of the dopants from the dopant diffusing agents can be controlled through the presence or absence of finely formed thick film portions 2a of diffusion suppressing mask 2, whereby the interval between first conductivity type dopant diffusion layer 5a and second conductivity type dopant diffusion layer 6a formed on the rear surface of semiconductor substrate 1 can be stably set to a prescribed small interval as compared with the method described in the aforementioned Patent Document 2.

In the rear electrode type solar cell producing method according to this embodiment, no steps of patterning diffusion suppressing mask 2 (forming openings 2b of diffusion suppressing mask 2) for forming first conductivity type dopant diffusion layer 5a and second conductivity type dopant diffusion layer 6a may be carried out in the formation of first conductivity type dopant diffusion layer 5a and in the formation of second conductivity type dopant diffusion layer 6a (twice in total), whereby the producing steps can be simplified.

In the rear electrode type solar cell producing method according to this embodiment, the heat treatment for forming first conductivity type dopant diffusion layer 5a and second conductivity type dopant diffusion layer 6a may be carried out only once, whereby the producing steps can be simplified, and thermal damage of semiconductor substrate 1 etc. resulting from the heat treatment can be effectively suppressed.

While first conductivity type dopant diffusing agent 3 is applied to cover diffusion suppressing mask 2 and second conductivity type dopant diffusing agent 4 in this embodiment, second conductivity type dopant diffusing agent 4 may be formed to cover diffusion suppressing mask 2 and first conductivity type dopant diffusing agent 3 by replacing the first conductivity type and the second conductivity type with each other.

Description of this embodiment other than the above is similar to those of the tenth to thirteenth embodiments, and hence redundant description is not repeated.

### <Fifteenth Embodiment>

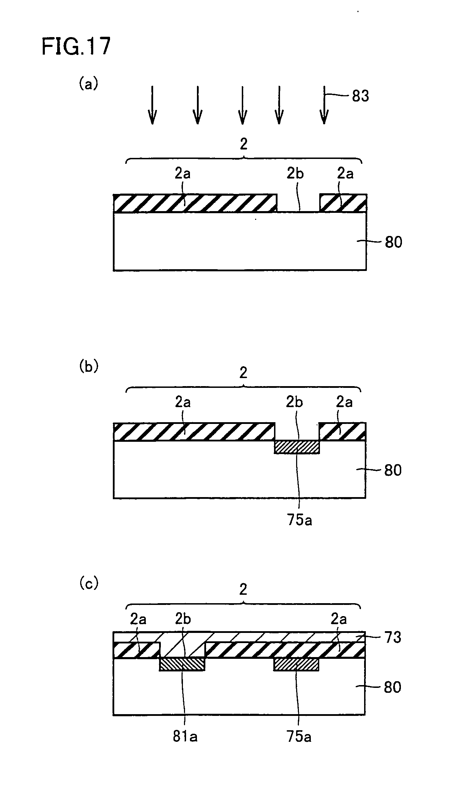

This embodiment is characterized in a point that a p-type dopant diffusion layer and an n-type dopant diffusion layer are individually formed. A rear electrode type solar cell producing method according to this embodiment is now described with reference to schematic sectional views of Fig. 17(a) to Fig. 17(c).

First, an n-type silicon substrate 80 provided with a diffusion suppressing mask 2 having thick film portions 2a and an opening 2b on one surface is exposed to dopant gas 83 such as POCl₃ containing phosphorus, as shown in Fig. 17(a). At this time, n-type silicon substrate 80 can be exposed to dopant gas 83 containing phosphorus in a state heat-treated to a temperature of 850°C to 950°C, for example, for 20 minutes to 30 minutes, for example.

Thus, phosphorus diffuses into the surface of n-type silicon substrate 80 through opening 2b of diffusion suppressing mask 2 on n-type silicon substrate 80 so that an n-type dopant diffusion layer 75a is formed while phosphorus does not diffuse into the surface of n-type silicon substrate 80 through thick film portions 2a of diffusion suppressing mask 2, as shown in Fig. 17(b).

Then, diffusion suppressing mask 2 formed on the surface of n-type silicon substrate 80 is temporarily entirely removed, thereafter another diffusion suppressing mask 2 having an opening 2b and thick film portions 2a is formed again, thereafter a p-type dopant diffusing agent 73 containing boron is applied to cover diffusion suppressing mask 2 and n-type silicon substrate 80 is thereafter heat treated, whereby a p-type dopant diffusion layer 81a is formed, as shown in Fig. 17(c). At this time, n-type silicon substrate 80 can be heated to a temperature of 950°C to 1000°C, for example, for 50 minutes, for example.

Boron diffuses into the surface of n-type silicon substrate 80 through opening 2b of diffusion suppressing mask 2 on n-type silicon substrate 80 so that p-type dopant diffusion layer 81a is formed, while diffusion of boron into the surface of n-type silicon substrate 80 is prevented by thick film portions 2a of diffusion suppressing mask 2. Thereafter a rear electrode type solar cell is prepared similarly to the tenth to fourteenth embodiments.

In the rear electrode type solar cell producing method according to this embodiment which is an example of the present invention, the presence or absence of diffusion of the dopants from the dopant-containing gas and the dopant diffusing agent can be controlled through the presence or absence of finely formed thick film portions 2a of diffusion suppressing mask 2, whereby the interval between n-type dopant diffusion layer 75a and p-type dopant diffusion layer 81a formed on the rear surface of n-type silicon substrate 80 can be stably set to a prescribed small interval as compared with the method described in the aforementioned Patent Document 2.

Description of this embodiment other than the above is similar to those of the tenth to fourteenth embodiments, and hence redundant description is not repeated.

### <Sixteenth Embodiment>

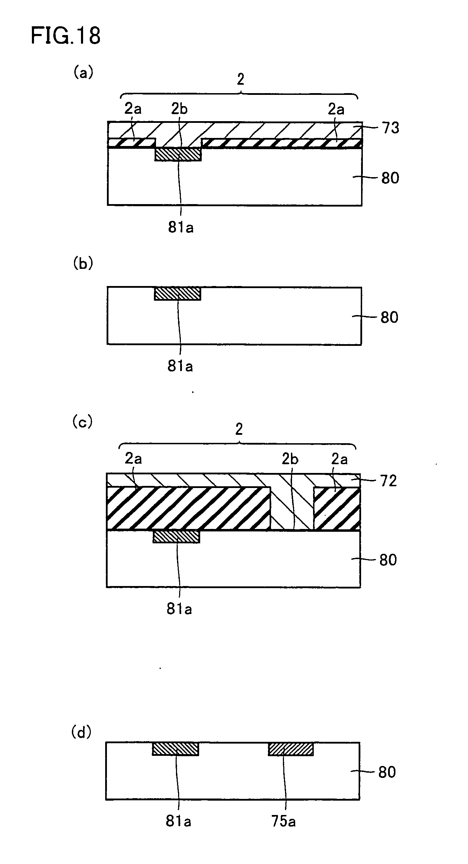

This embodiment is also characterized in a point that a p-type dopant diffusion layer and an n-type dopant diffusion layer are individually formed. A rear electrode type solar cell producing method according to this embodiment is now described with reference to schematic sectional views of Fig. 18(a) to Fig. 18(d).

First, a p-type dopant diffusing agent 73 containing boron is applied to cover a diffusion suppressing mask 2 having thick film portions 2a and an opening 2b formed on one surface of an n-type silicon substrate 80 and n-type silicon substrate 80 is thereafter heat-treated, for forming a p-type dopant diffusion layer 81a on the surface of n-type silicon substrate 80, as shown in Fig. 18(a). At this time, n-type silicon substrate 80 can be heated to a temperature of 950°C to 1000°C, for example, for 50 minutes, for example.

Boron diffuses into the surface of n-type silicon substrate 80 through opening 2b of diffusion suppressing mask 2 on n-type silicon substrate 80 so that p-type diffusion layer 81a is formed, while boron does not diffuse into the surface of n-type silicon substrate 80 through thick film portions 2a of diffusion suppressing mask 2.

Then, diffusion suppressing mask 2 formed on the surface of n-type silicon substrate 80 is entirely removed, as shown in Fig. 18(b).

Then, another diffusion suppressing mask 2 including thick film portions 2a and an opening 2b is formed on the surface of n-type silicon substrate 80 and an n-type dopant diffusing agent 72 containing phosphorus is thereafter applied to cover diffusion suppressing mask 2, as shown in Fig. 18(c).

Thereafter n-type silicon substrate 80 is heat-treated to a temperature of 850°C to 950°C, for example, for 20 minutes to 30 minutes, whereby phosphorus diffuses into the surface of n-type silicon substrate 80 through opening 2b of diffusion suppressing mask 2 on n-type silicon substrate 80 so that an n-type dopant diffusion layer 75a is formed while diffusion of phosphorus is prevented by thick film portions 2a of diffusion suppressing mask 2, as shown in Fig. 18(d). Thereafter diffusion suppressing mask 2 and n-type dopant diffusing agent 72 are entirely removed. Thereafter a rear electrode type solar cell is prepared similarly to the tenth to fourteenth embodiments.

In the rear electrode type solar cell producing method according to this embodiment which is an example of the present invention, the presence or absence of diffusion of the dopants from the dopant diffusing agents can be controlled through the presence or absence of finely formed thick film portions 2a of diffusion suppressing mask 2, whereby the interval between n-type dopant diffusion layer 75a and p-type dopant diffusion layer 81a formed on the rear surface of n-type silicon substrate 80 can be stably set to a prescribed small interval as compared with the method described in the aforementioned Patent Document 2.

Description of this embodiment other than the above is similar to those of the tenth to fourteenth embodiments, and hence redundant description is not repeated.

### <Seventeenth Embodiment>

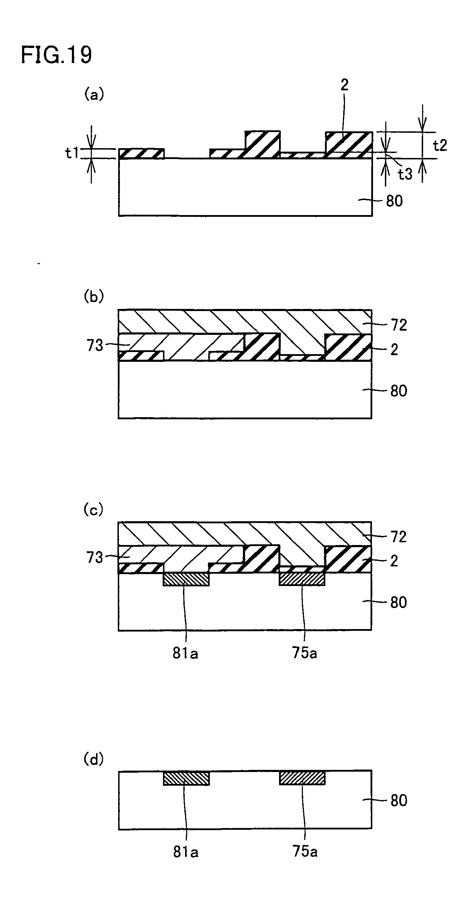

This embodiment is characterized in a point that a diffusion suppressing mask is formed to have various thicknesses. A rear electrode type solar cell producing method according to this embodiment is now described with reference to schematic sectional views of Fig. 19(a) to Fig. 19(d).

First, a diffusion suppressing mask 2 is formed on the surface of an n-type silicon substrate 80, as shown in Fig. 19(a). Diffusion suppressing mask 2 is constituted of portions having a thickness t1, an opening, portions having a thickness t2 and a portion having a thickness t3. The thickness t1, the thickness t2 and the thickness t3 are so set as to satisfy the relation of thickness t2 > thickness t1 > thickness t3.

The thickness t 1 can be set to at least 100 nm and not more than 400 nm, for example, and more specifically, the same can be set to about 200 nm.

The thickness t2 can be set to at least 400 nm, for example, and more specifically, the same can be set to about 400 nm.

The thickness t3 can be set to at least 50 nm and not more than 250 nm, for example, and more specifically, the same can be set to about 100 nm.

Then, a p-type dopant diffusing agent 73 containing boron is applied and an n-type dopant diffusing agent 72 containing phosphorus is thereafter applied to cover p-type dopant diffusing agent 73 and diffusion suppressing mask 2, as shown in Fig. 19(b).

Then, n-type silicon substrate 80 is heat-treated for forming a p-type dopant diffusion layer 81a and an n-type dopant diffusion layer 75a on the surface of n-type silicon substrate 80, as shown in Fig. 19(c).

Boron diffuses into the surface of n-type silicon substrate 80 through an opening 2b of diffusion suppressing mask 2 on n-type silicon substrate 80 so that p-type dopant diffusion layer 81a is formed, while boron is not diffused into the surface of n-type silicon substrate 80 through the portions of diffusion suppressing mask 2 having the thickness t1.

Further, phosphorus diffuses into the surface of n-type silicon substrate 80 through the portion of diffusion suppressing mask 2 on n-type silicon substrate 80 having the thickness t3 so that n-type dopant diffusion layer 75a is formed, while phosphorus does not diffuse into the surface of n-type silicon substrate 80 through the portions of diffusion suppressing mask 2 having the thickness t2.

In addition, phosphorus more easily deeply diffuses into n-type silicon substrate 80 than boron, whereby the depths of n-type dopant diffusion layer 75a resulting from diffusion of phosphorus and p-type dopant diffusion layer 81a resulting from diffusion of boron can be rendered substantially equivalent to each other by forming diffusion suppressing mask 2 so that the relation of thickness t2 of diffusion suppressing mask 2 > thickness t1 of diffusion suppressing mask 2 > thickness t3 of diffusion suppressing mask 2 is satisfied.

Then, diffusion suppressing mask 2 formed on the surface of n-type silicon substrate 80 is entirely removed, as shown in Fig. 19(d). Thereafter a rear electrode type solar cell is prepared similarly to the tenth to fourteenth embodiments.

In the rear electrode type solar cell producing method according to this embodiment which is an example of the present invention, the presence or absence of diffusion of the dopants from the dopant diffusing agents can be controlled through the presence or absence of the finely formed pattern of diffusion suppressing mask 2, whereby the interval between n-type dopant diffusion layer 75a and p-type dopant diffusion layer 81a formed on the rear surface of n-type silicon substrate 80 can be stably set to a prescribed small interval as compared with the method described in the aforementioned Patent Document 2.

Description of this embodiment other than the above is similar to those of the tenth to fourteenth embodiments, and hence redundant description is not repeated.

All semiconductor devices including a solar cell are included in the concept of the semiconductor device according to the present invention. Further, not only a rear electrode type solar cell having such a structure that both of a p-type electrode and an n-type electrode are formed only on one surface (rear surface) of a semiconductor substrate, but also solar cells of all structures such as the so-called back contact type solar cell (solar cell having such a structure that a current is extracted from a rear surface of a semiconductor substrate opposite to a photoreceiving surface) such as an MWT (Metal Wrap Through) cell (solar cell having such a structure that part of an electrode is arranged in a through-hole provided in a semiconductor substrate) and a double electrode type solar cell produced by forming electrodes on a photoreceiving surface and a rear surface of a semiconductor substrate respectively are included in the concept of the solar cell according to the present invention.

The embodiments disclosed this time must be considered as illustrative and not restrictive in all points. The range of the present invention is shown not by the above description but by the scope of claims for patent, and it is intended that all modifications within the meaning and range equivalent to the scope of claims for patent are included.

### INDUSTRIAL APPLICABILITY

According to the present invention, a semiconductor device producing method by which a high-concentration dopant diffusion layer and a low-concentration dopant diffusion layer can be stably formed on desired positions can be provided, whereby the present invention can be suitably utilized for producing a semiconductor device such as a solar cell having a structure including electrodes on a photoreceiving surface and a rear surface of a semiconductor substrate respectively or a rear electrode type solar cell having a structure including an electrode only on a rear surface of a semiconductor substrate.

Further, the present invention can provide a producing method for a semiconductor device such as a rear electrode type solar cell by which the interval between a first conductivity type dopant diffusion layer and a second conductivity type dopant diffusion layer formed on a rear surface of a semiconductor substrate can be set to a prescribed small interval.

### REFERENCE SIGNS LIST

1 semiconductor substrate, 2 diffusion suppressing mask, 2a thick film portion, 2b opening, 2c thin film portion, 3 first conductivity type dopant diffusing agent, 4 second conductivity type dopant diffusing agent, 5 high-concentration first conductivity type dopant diffusion layer, 5a first conductivity type dopant diffusion layer, 6 high-concentration second conductivity type dopant diffusion layer, 6a second conductivity type dopant diffusion layer, 7 passivation film, 8 textured structure, 9 reflection preventing film, 10 first conductivity type electrode, 10a first conductivity type collecting electrode, 11a second conductivity type collecting electrode, 15 first conductivity type dopant-containing gas, 16 low-concentration first conductivity type dopant diffusion layer, 17 low-concentration second conductivity type dopant diffusion layer, 20 alignment mark, 71 p-type semiconductor substrate, 72 n-type dopant diffusing agent, 73 p-type dopant diffusing agent, 74 p-type dopant diffusion layer, 75 high-concentration n-type dopant diffusion layer, 75a n-type dopant diffusion layer, 76 low-concentration n-type dopant diffusion layer, 77 n electrode, 78 p electrode, 80 n-type silicon substrate, 81 high-concentration p-type dopant diffusion layer, 81a p-type dopant diffusion layer, 82 low-concentration p-type dopant diffusion layer, 83 dopant gas containing phosphorus, 100 silicon substrate, 101 low-concentration n-type dopant source, 102 high-concentration n-type dopant source, 103 low-concentration p-type dopant source, 104 high-concentration p-type dopant source, 105 high-concentration n-type dopant diffusion layer, 106 high-concentration p-type dopant diffusion layer, 108 textured structure, 115 low-concentration p-type dopant diffusion layer, 116 low-concentration n-type dopant diffusion layer, 200 silicon substrate, 201 textured structure, 202 reflection preventing film, 203 boron paste, 204 phosphorus paste, 205 silicon oxide film, 206 p⁺ layer, 207 n⁺ layer.

## Claims

1. A semiconductor device producing method comprising the steps of:
forming a diffusion suppressing mask (2) having an opening (2b) and a thick film portion (2a) on a surface of a semiconductor substrate (1);
applying a dopant diffusing agent (3, 4, 72, 73) containing a first conductivity type or second conductivity type dopant to cover at least part of a surface of said diffusion suppressing mask (2);
forming a high-concentration dopant diffusion layer (5, 6, 75, 81) by diffusing said dopant into said surface of said semiconductor substrate (1) from said dopant diffusing agent (3, 4, 72, 73) through said opening (2b) of said diffusion suppressing mask (2); and
forming a low-concentration dopant diffusion layer (16, 17, 76, 82) by diffusing said dopant into said surface of said semiconductor substrate (1) from said dopant diffusing agent (3, 4, 72, 73) through said thick film portion (2a) of said diffusion suppressing mask (2).

2. A semiconductor device producing method comprising the steps of:
forming a diffusion suppressing mask (2) having a thin film portion (2c) and a thick film portion (2a) having a larger film thickness than said thin film portion (2c) on a surface of a semiconductor substrate (1);
applying a dopant diffusing agent (3, 4, 72, 73) containing a first conductivity type or second conductivity type dopant to cover at least part of a surface of said diffusion suppressing mask (2);
forming a high-concentration dopant diffusion layer (5, 6, 75, 81) by diffusing said dopant into said surface of said semiconductor substrate (1) from said dopant diffusing agent (3, 4, 72, 73) through said thin film portion (2c) of said diffusion suppressing mask (2); and
forming a low-concentration dopant diffusion layer (16, 17, 76, 82) by diffusing said dopant into said surface of said semiconductor substrate (1) from said dopant diffusing agent (3, 4, 72, 73) through said thick film portion (2a) of said diffusion suppressing mask (2).

3. A semiconductor device producing method comprising the steps of:
forming a diffusion suppressing mask (2) having an opening (2b), a thin film portion (2c) and a thick film portion (2a) having a larger film thickness than said thin film portion (2c) on a surface of a semiconductor substrate (1);
applying a dopant diffusing agent (3, 4, 72, 73) containing a first conductivity type or second conductivity type dopant to cover at least part of a surface of said diffusion suppressing mask (2);
forming a high-concentration dopant diffusion layer (5, 6, 75, 81) by diffusing said dopant into said surface of said semiconductor substrate (1) from said dopant diffusing agent (3, 4, 72, 73) through at least one of said opening (2b) and said thin film portion (2c) of said diffusion suppressing mask (2); and
forming a low-concentration dopant diffusion layer (16, 17, 76, 82) by diffusing said dopant into said surface of said semiconductor substrate (1) from said dopant diffusing agent (3, 4, 72, 73) through said thick film portion (2a) of said diffusion suppressing mask (2).

4. The semiconductor device producing method according to claim 1, further comprising a step of diffusing said dopant into said step of said semiconductor substrate (1) from dopant-containing gas (15,83) containing the first conductivity type or second conductivity type dopant through said diffusion suppressing mask (2).

5. The semiconductor device producing method according to claim 1, wherein the dopant concentration in said high-concentration dopant diffusion layer (5, 6, 75, 81) is at least 1 × 10¹⁹/cm³.

6. The semiconductor device producing method according to claim 1, wherein the dopant concentration in said low-concentration dopant diffusion layer (16, 17, 76, 82) is at least 1 × 10¹⁷/cm³ and less than 1 × 10¹⁹/cm³.

7. A semiconductor device producing method comprising the steps of:
forming a diffusion suppressing mask (2) having an opening (2b) and a thick film portion (2a) on a surface of a semiconductor substrate (1);
applying a dopant diffusing agent (3, 4, 72, 73) containing a first conductivity type or second conductivity type dopant to cover at least part of a surface of said diffusion suppressing mask (2); and
diffusing said dopant into said surface of said semiconductor substrate (1) from said dopant diffusing agent (3, 4, 72, 73).

8. The semiconductor device producing method according to claim 7, forming a dopant diffusion layer (5a, 6a, 75a, 81a) on a surface region of said semiconductor substrate (1) corresponding to said opening (2b) of said diffusion suppressing mask (2) in the step of diffusing said dopant.

9. A semiconductor device producing method comprising the steps of:
forming a diffusion suppressing mask (2) having a thin film portion (2c) and a thick film portion (2a) having a larger film thickness than said thin film portion (2c) on a surface of a semiconductor substrate (1);
applying a dopant diffusing agent (3, 4, 72, 73) containing a first conductivity type or second conductivity type dopant to cover at least part of a surface of said diffusion suppressing mask (2); and
diffusing said dopant into said surface of said semiconductor substrate (1) from said dopant diffusing agent (3, 4, 72, 73).

10. The semiconductor device producing method according to claim 9, forming a dopant diffusion layer (3, 4, 72, 73) on a surface region of said semiconductor substrate (1) corresponding to said thin film portion (2c) of said diffusion suppressing mask (2) in the step of diffusing said dopant.

11. A semiconductor device producing method comprising the steps of:
forming a diffusion suppressing mask (2) having an opening (2b), a thin film portion (2c) and a thick film portion (2a) having a larger film thickness than said thin film portion (2c) on a surface of a semiconductor substrate (1);
applying a dopant diffusing agent (3, 4, 72, 73) containing a first conductivity type or second conductivity type dopant to cover at least part of a surface of said diffusion suppressing mask (2); and
diffusing said dopant into said surface of said semiconductor substrate (1) from said dopant diffusing agent (3, 4, 72, 73).

12. The semiconductor device producing method according to claim 11, forming a dopant diffusion layer (3, 4, 72, 73) on surface regions of said semiconductor substrate (1) corresponding to said opening (2b) and said thin film portion (2c) of said diffusion suppressing mask (2) respectively.

13. The semiconductor device producing method according to claim 7, further comprising a step of diffusing said dopant into said surface of said semiconductor substrate (1) from dopant-containing gas (15, 83) containing the first conductivity type or second conductivity type dopant.

14. The semiconductor device producing method according to claim 7,
wherein
said thick film portion (2a) has a thickness preventing said dopant from reaching the surface of said semiconductor substrate (1).

15. A semiconductor device comprising:
a semiconductor substrate (1), and
a high-concentration first conductivity type dopant diffusion layer (5), a high-concentration second conductivity type dopant diffusion layer (6), a low-concentration first conductivity type dopant diffusion layer (16) and a low-concentration second dopant diffusion layer (17) formed on one surface side of said semiconductor substrate (1), wherein
said high-concentration first conductivity type dopant diffusion layer (5) and said high-concentration second conductivity type dopant diffusion layer (6) are formed at an interval,
said low-concentration first conductivity type dopant diffusion layer (16) is arranged adjacently to said high-concentration first conductivity type dopant diffusion layer (5) while said low-concentration second conductivity type dopant diffusion layer (17) is arranged adjacently to said high-concentration second conductivity type dopant diffusion layer (6), and
said low-concentration first conductivity type dopant diffusion layer (16) and said low-concentration second conductivity type dopant diffusion layer (17) are adjacent to each other between said high-concentration first conductivity type dopant diffusion layer (5) and said high-concentration second conductivity type dopant diffusion layer (6).
